# EUROPÄISCHE PATENTSCHRIFT

(11) **EP 3 503 365 B1**
(45) Veröffentlichungstag und Bekanntmachung des Hinweises auf die Patenterteilung: **10.06.2020**
(21) Anmeldenummer: 17210481.2
(22) Anmeldetag: 22.12.2017
(51) Int. Cl.: H02M 1/08, H03K 17/00, H02M 1/44, H02M 7/538

(54) **VERFAHREN UND EINRICHTUNG ZUR ANSTEUERUNG VON MOSFET-SCHALTMODULEN**
METHOD AND DEVICE FOR CONTROLLING MOSFET SWITCHING MODULES
PROCÉDÉ ET DISPOSITIF DE COMMANDE DE MODULES DE COMMUTATION MOS À EFFET DE CHAMP

(43) Veröffentlichungstag der Anmeldung: 26.06.2019
(73) Patentinhaber: GE Energy Power Conversion Technology Limited, Rugby Warwickshire CV21 1BU (GB)
(72) Erfinder: SZCZUPAK Piotr, 12277 Berlin (DE); GLOES Hendrik, 12277 Berlin (DE); GESKE Martin, 12277 Berlin (DE)
(74) Vertreter: Rüger Abel Patentanwälte PartGmbB

(56) Entgegenhaltungen:
- US-A1- 2003 107 905
- US-A1- 2008 265 975
- US-A1- 2015 137 871

## Beschreibung

Die vorliegende Anmeldung betrifft allgemein die Ansteuerung von Leistungs-MOSFET (Metal-Oxide-Semiconductor Field-Effect Transistor, Metall-Oxid-Halbleiter-Feldeffekttransistor) - Schaltmodulen und insbesondere ein Verfahren und eine Einrichtung zur Steuerung eines Kommutierungsvorgangs eines Laststroms von einem ersten Leistungs-MOSFET-Schaltmodul auf ein zweites Leistungs-MOSFET-Schaltmodul.

Leistungshalbleiterschalter werden in unterschiedlichen technischen Bereichen, bspw. in Stromrichtern zur Umformung elektrischer Energie als auch zur Steuerung des Energieflusses, wie bspw. für elektrische Maschinen, Motoren, Generatoren, in Stromrichtern zur Energieübertragung, -wandlung und für andere Anwendungen verwendet. Sie können zum Schalten hoher Spannungen, bis zu einigen kV, bei hohen Schaltfrequenzen, bis in den hohen kHz-Bereich, eingesetzt werden. Während sich für geregelte Antriebe, Energieversorgungs- und -übertragungsanwendungen insbesondere Bipolartransistoren mit isolierter Gate-Elektrode (IGBTs) durchgesetzt haben, werden bei hohen Schaltfrequenzen und geringeren Spannungen Metall-Oxid-Halbleiter-Feldeffekttransistoren (MOSFETs) bevorzugt. Angesichts steigender Energiekosten, eines zunehmenden Umweltbewusstseins und hohen Wettbewerbsdrucks besteht ein fortwährender Wunsch nach neuen Leistungshalbleiterschaltern und den daraus gebildeten Leistungsmodulen, die in ihrem Aufbau kompakter, niederinduktiver und in der Herstellung kostengünstiger und effizienter sind und ein verbessertes Betriebsverhalten, eine höhere Leistungsdichte und einen besseren Wirkungsgrad ermöglichen.

Für konventionelle Anwendungen im Schaltbetrieb müssen die Leistungshalbleiterschalter in der Lage sein, eine Sperrspannung aufzunehmen. Standard-IGBTs sind aufgrund ihres strukturbedingten Aufbaus nur in der Lage, in eine Richtung Spannung aufzunehmen und Strom zu führen. Daher wird üblicherweise eine separate Freilaufdiode antiparallel zu dem IGBT-Bauelement geschaltet, die die entsprechende Sperrspannung aufnehmen kann und eine Stromführung in Rückwärtsrichtung ermöglicht. Dies erhöht in der Regel das Bauvolumen, den Aufwand für den Aufbau und die Verbindungstechnik als auch die Chipfläche und damit die Kosten des Schaltmoduls.

Es sind auch IGBTs bekannt, in der eine Freilaufdiode monolitisch integriert ist und die als rückwärtsleitfähige IGBTs (kurz RC-IGBTs) bezeichnet werden. Während das Leitverhalten einer gesonderten, zu dem IGBT antiparallel geschalteten Diode von dem Ansteuerzustand des IGBTs unabhängig ist, zeigt die integrierte Diode eines RC-IGBTs eine Abhängigkeit von dem Ansteuerzustand des IGBTs. Wird der RC-IGBT im Rückwärtsleitbetrieb, wenn die innere Diode Strom führt, eingeschaltet, so entsteht ein zusätzlicher, zu der inneren Diode paralleler Strompfad, so dass nicht mehr alle Elektronen zur Überschwemmung der inneren PIN-Diodenstruktur beitragen können. Dies kann zu einem unerwünschten, erhöhten Spannungsabfall über der Diode bzw. dem IGBT im Rückwärtsleitbetrieb führen, der erhöhte Halbleiterverluste zur Folge hat.

Um dies zu verhindern, schlägt die DE 10 2009 001 029 A1 eine Einrichtung und ein Verfahren zur Ansteuerung eines RC-IGBTs vor, die Treibersignale zur Ansteuerung der Gate-Elektrode erzeugen, um den RC-IGBT entsprechend einem Steuersignal ein- und auszuschalten, wobei ein Einschalten des RC-IGBTs blockiert wird, wenn der IGBT in Rückwärtsrichtung Strom führt, womit eine Stromrichtungserkennung für die Ansteuerung und den Betrieb des Bauelements notwendig ist.

IGBTs weisen aufgrund ihres bipolaren Charakters einen als Tailstrom bezeichneten Stromschweif auf und zeigen ein langsameres Schaltverhalten im Vergleich zu unipolaren Bauelementen wie den MOSFET's. Die Sperr- bzw. Umkehr-Erholungszeit eines bipolaren Aufbaus sowie die vergleichsweise höheren Schaltenergien, verursacht durch Majoritäts- und Minoritätsladungsträgeranteile, begrenzen thermisch die maximale Schaltfrequenz. Insofern werden für Anwendungen mit hoher Anforderung an die Schaltfrequenz zunehmend MOSFETs auch bei höheren Spannungen über 1000V eingesetzt. Darüber hinaus tritt bei einem MOSFET keine Schleusenspannung auf. Das Durchlassverhalten sowie die Leitverluste werden bei dem MOSFET durch ein ohmsches Verhalten bestimmt, das als Widerstand R_{DS(on)} charakterisiert wird. Der R_{DS(on)} setzt sich aus unterschiedlichen Widerstandsanteilen bestehend aus dem Kanal, der Driftzone, der Anreicherungsschicht, dem Substrat und anderen kleineren Beträgen zusammen. Insbesondere bieten in jüngerer Zeit entwickelte MOSFETs auf Basis von Siliziumkarbid (SiC) im Vergleich zu herkömmlichen IGBTs auf Siliziumbasis beträchtliche Vorteile im Hinblick auf die Schaltgeschwindigkeit und die maximale Sperrschichttemperatur. SiC-MOSFETs profitieren von einem größeren Bandabstand, der durch eine höhere kritische Feldstärke vergleichsweise dünnere Bauelemente ermöglicht, die den Materialaufwand und die Durchlassverluste verringern. Weiterhin ermöglicht der größere Bandabstand höhere Betriebstemperaturen, die wiederum eine verbesserte Ausnutzung der Bauelemente ermöglichen, die Leistungsdichte erhöhen und den Aufwand für das Kühlsystem der Halbleiter verringern. Die Entwicklung von SiC-MOSFETs ist technologisch noch nicht abgeschlossen, wodurch geeignete Ansteuerungsstrategien zusätzliche Vorteile bieten können.

Was MOSFET-Bauelemente allgemein anbetrifft, kann, wenn Rückwärtsleitfähigkeit gefordert ist, dafür deren intrinsische Diode verwendet werden. Der MOSFET bildet als doppelt diffundierte Struktur (DMOS) eine innere Diode aus, die auch als Inversdiode oder Körperdiode bezeichnet wird. In dieser Struktur bildet sie typischerweise eine PIN-Diode, die in Rückwärtsrichtung von dem mit Source verbundenen Substrat, über Mittelgebiet bis zum Drainkontakt einen Stromfluss ermöglicht. Gegenüber einer optimierten, diskreten Freilaufdiode, die in der Regel an den IGBT angepasst ist oder entsprechend ausgewählt wird, ist die intrinsische Inversdiode des MOSFETs hinsichtlich des Schaltverhaltens unterlegen und führt in der Regel zu erhöhten Schaltverlusten durch höhere Speicherladung und gegebenenfalls größere Rücksstromspitzen. Die intrinsischen Dioden sind in der Regel nicht oder nur begrenzt optimierbar, wodurch die Verteilung der Ladungsträger im Bauelement und deren Dynamik während des Abschaltens zu hochfrequenten Oszillationen und einem snappigen Schaltverhalten führen kann, die durch eine geeignete Beschaltung, Anpassung der Ansteuerung oder durch ein geeignetes Design des Halbleiteraufbaus kompensiert oder optimiert werden müssen. Die Verwendung der Inversdiode eines MOSFETs ermöglicht aber eine Reduktion des Platzbedarfs, der verwendeten Chipfläche als auch des Aufbaus und der Verbindungstechnik des Schaltmoduls. In Verbindung mit dem unipolaren Aufbau eines MOSFETs ermöglicht sie ferner eine mögliche Reduktion der Sperrverzugszeit und folglich höhere Schaltfrequenzen. Für Anwendungen, die vornehmlich für den Stromrichterbetrieb vorgesehen sind, ist die Einsparung einer diskreten, zusätzlichen Diode ein erheblicher Kostenvorteil, der für die jeweilige Anwendung und deren Anforderung in Betracht gezogen werden kann. Für Anwendungen im Wechselrichterbetrieb werden Dioden im Vergleich zu den schaltenden Elementen nur geringfügig verwendet, die eine Einsparung diskreter Dioden bei Verwendung von MOSFETs ermöglichen kann.

Ein Nachteil von MOSFETs, einschließlich SiC-MOSFETs, besteht in deren starker Abhängigkeit des Schaltverhaltens von den parasitären Schaltkreisparametern. Insbesondere neigt ein MOSFET-Schaltmodul beim Abschalten, wenn der Stromfluss von einer Inversdiode abkommutiert, zu starken Oszillationen, die auf die Streuinduktivitäten und parasitären Kapazitäten des Schaltmoduls in Kombination mit den sehr kurzen Anstiegszeiten und dem gegebenenfalls snappigen Abschaltverhalten durch einen abrupten Rückstromabriss der Inversdiode zurückzuführen sind. Die Oszillationen während und nach den Schalttransienten haben erhöhte Schaltverluste, hohe Spannungsspitzen und stärkere elektromagnetische Störausstrahlungen zur Folge. Letztere machen aufwendige Maßnahmen zur Verbesserung der elektromagnetischen Verträglichkeit (EMV) hinsichtlich der Robustheit als auch Störaussendung mit entsprechend erhöhten Fertigungs- und Komponentenkosten erforderlich.

Die Stromtragfähigkeit von SiC-MOSFETs ist relativ begrenzt. In Anwendungen mit höheren Strömen müssen deshalb mehrere MOSFET-Schaltmodule parallel zueinander geschaltet werden, um die benötigte Stromtragfähigkeit zu erzielen. Die Oszillationen der abkommutierenden Körperdioden wirken sich hier besonders nachteilig aus, weil diese Oszillationen der parallel geschalteten Inversdioden einander gegenseitig beeinflussen und verstärken können. Eine Reduktion dieser Oszillationen wäre für eine Parallelisierung der Schaltmodule äußerst wichtig.

Eine übliche Methode zur Reduktion von derartigen Oszillationen von Inversdioden von MOSFET-Schaltmodulen nach Schalttransienten besteht darin, die Gate-Widerstände beim Umschaltvorgang zu erhöhen. Bspw. beschreibt die Dissertation von Li, Helong "Parallel Connection of Silicon Carbide MOSFETs for Multichip Power Modules", Department of Energy Technology, Aalborg University, Denmark, 2015, Auswirkungen erhöhter Einschalt- und Ausschalt-Gate-Widerstände auf das Schaltverhalten von SiC-MOSFET-Schaltmodulen. Durch Erhöhung des Gate-Widerstands können Oszillationen verringert werden, wobei jedoch dadurch die Schaltverluste steigen. Generell besteht aber der Wunsch, sowohl die Durchlass- als auch die Schaltverluste auf ein Minimum zu reduzieren.

In der Publikation von Zhenxue Xu et al. "An Analysis and Experimental Approach to MOS Controlled Diodes Behavior", IEEE TRANSACTIONS ON POWER ELECTRONICS, Vol. 15, No. 5, September 2000, werden unterschiedliche Inversdioden von Leistungs-MOSFETs untersucht und hinsichtlich ihres Verhaltens beschrieben, wie die Speicherladung und die Rückstromspitze der Inversdioden für die Kommutierung durch geeignete Ansteuerung des MOSFETs verringert werden kann. Dabei wird das Bauelement generell als Diode bzw. in Diodenstromrichtung in Tiefsetzstellerschaltung verwendet. Für die Kommutierung wird der gesamte Strom über den durch U_{GS} geöffneten unipolaren Kanal des MOSFETs geführt, während der Kanal für den Leitendbetrieb geschlossen ist und die bipolare Struktur der PIN-Diode allein wirksam ist. Für die Kommutierung mit geöffnetem Kanal ist die Durchlassspannung des Bauelements geringer als die Schleusenspannung der Körperdiode und es wird der unipolare Kanal des MOSFETs zur Kommutierung verwendet, wodurch die Speicherladung und die Rückstromspitze verringert werden.

DE 103 23 445 B4 beschreibt eine getaktete Gleichstrom-Steuerschaltung zum Kommutieren eines Stromflusses zwischen zwei gesteuerten Leistungsbauteilen, insbesondere MOSFETs, die nach Art einer Tiefsetzstellerschaltung verschaltet sind und betrieben werden. Insbesondere ist eines der beiden Leistungsbauteile als Schaltelement geschaltet, während das andere Leistungsbauteil als Freilaufelement geschaltet ist. Nach dem Einleiten des Ausschaltvorgangs des Schaltelementes wird das Einschalten des Freilaufelementes eingeleitet, wobei der Ausschaltvorgang des Schaltelementes verzögert wird und danach das Schaltelement vollständig ausgeschaltet wird und wobei das Einschalten des Freilaufelementes während einer vorbestimmten Zeitdauer während des vollständigen Ausschaltens des Schaltelementes verzögert wird und danach vollständig eingeschaltet wird. Durch die Verwendung des gesteuerten Freilaufelementes wird erreicht, dass nicht die relativ langsame und störkritische intrinsische Freilaufdiode des Schaltelementes die Kommutierung bestimmt, sondern das andere Leistungsbauteil, das beliebig schnell schaltbar ist und als Freilaufelement dient. Durch die aktive Ansteuerung des von dem geschalteten Schaltelement gesonderten Freilaufelements können Verluste minimiert werden, ohne zusätzliche Störaussendungen zu erzeugen.

US 2003/0107905 A1 beschreibt ein Verfahren und eine Einrichtung zur Steuerung eines Kommutierungsvorgangs eines Laststroms von einem ersten MOSFET auf einen zweiten MOSFET, die in Reihe miteinander verbunden sind und jeweils eine intrinsische Inversdiode aufweisen, die als Freilaufdiode dient. Der erste und der zweite MOSFET sind durch eine Gate-Source-Spannung ansteuerbar, um eingeschaltet oder ausgeschaltet zu werden. Zur Beeinflussung des Abschaltverhaltens der Inversdiode sind ein Kondensator, der zwischen dem Drain und dem Gate jedes MOSFETs geschaltet ist, und ein Widerstand vorgesehen, der zwischen dem Gate und dem Gate-Treiber des MOSFETs geschaltet ist. Gemäß dem Steuerungsverfahren wird zunächst eine erste Ansteuerspannung mit einem Wert unterhalb der Schwellenspannung an den ersten MOSFET zum Abschalten desselben angelegt, so dass dessen Gate-Spannung auf 0 Volt abfällt. Anschließend wird eine zweite Ansteuerspannung an den zweiten MOSFET zum Einschalten desselben angelegt. Der Freilaufstrom durch die Inversdiode des ersten MOSFETs nimmt ab und durchläuft den Wert null, so dass die Phase der Sperrerholung der Diode einsetzt, bis der Diodenfreilaufstrom sein Minimum erreicht und beginnt, wieder in Richtung positiver Werte anzusteigen. Im Bereich des Minimums wird durch einen parasitären Effekt, der durch die Kombination aus dem Kondensator und dem Widerstand hervorgerufen wird, die Gatespannung kurzzeitig auf einen Wert oberhalb der Schwellenspannung angehoben, woraufhin sie dann leicht oszillierend allmählich wieder auf 0 Volt abfällt. Dadurch können die ansonsten durch die Inversdiode bedingten Oszillationen und Spannungsspitzen der Drain-Source-Spannung verringert werden.

US 2015/0137871 A1 beschreibt ein Verfahren und eine Einrichtung zur Steuerung eines Kommutierungsvorgangs eines Laststroms von einem ersten MOSFET auf einen zweiten MOSFET, die in Reihe miteinander verbunden sind und jeweils eine intrinsische Inversdiode aufweisen, die als Freilaufdiode dient. Der erste und der zweite MOSFET sind durch eine Gate-Source-Spannung ansteuerbar, um eingeschaltet oder ausgeschaltet zu werden.

Ausgehend hiervon ist es eine Aufgabe der Erfindung, Maßnahmen vorzugschlagen, mit denen die vorstehend erwähnten Unzulänglichkeiten herkömmlicher unipolarer Leistungshalbleiterschalter beseitigt werden können. Insbesondere ist es eine Aufgabe der Erfindung, ein Verfahren und eine Einrichtung zur Steuerung eines Kommutierungsvorgangs eines Laststroms von einem ersten MOSFET-Schaltmodul auf ein zweites MOSFET-Schaltmodul zu schaffen, die es ermöglichen, die durch parasitäre Induktivitäten und Kapazitäten der MOSFET-Schaltmodule hervorgerufenen Oszillationen bei einer Kommutierung des Stromflusses von einer intrinsischen Inversdiode des MOSFET-Schaltmoduls während und nach entsprechenden Schalttransienten zu reduzieren, eine Parallelschaltbarkeit der Schaltmodule zu fördern und deren elektromagnetische Verträglichkeit zu verbessern. Insbesondere sollten das Verfahren und die Einrichtung zur Verwendung mit MOSFET-Schaltmodulen, z.B. auf SiC-Basis, für Stromrichter für unterschiedliche Anwendungen, einschließlich bei hochfrequenter Taktung der Schaltmodule, geeignet sein. Darüber hinaus sollten das Verfahren und die Einrichtung eine Ansteuerung ermöglichen, die eine verbesserte Kommutierung unabhängig von der Stromrichtung im abkommutierenden MOSFET-Schaltmodul erlaubt. In diesem Sinne soll das Verfahren im Allgemeinen, unabhängig von der Stromrichtung, in Stromrichtern einsetzbar sein.

Zur Lösung dieser Aufgabe sind ein Verfahren und eine Einrichtung zur Steuerung eines Kommutierungsvorgangs eines Laststroms von einem ersten Schaltmodul auf ein zweites Schaltmodul mit den Merkmalen des Anspruchs 1 bzw. 18 geschaffen. Besonders vorteilhafte Ausführungsformen der Erfindung sind Gegenstand der Unteransprüche.

Gemäß einem ersten Aspekt der Erfindung ist ein Verfahren zur Steuerung eines Kommutierungsvorgangs eines Laststroms von einem ersten Schaltmodul auf ein zweites Schaltmodul geschaffen, wobei das erste und das zweite Schaltmodul jeweils einen ersten bzw. zweiten MOSFET, also eine innere MOSFET-Struktur, und eine erste bzw. zweite intrinsische Inversdiode aufweisen. Der erste und der zweite MOSFET sind durch eine Gate-Source-Spannung ansteuerbar, um eingeschaltet, also leitend geschaltet, oder ausgeschaltet, also nichtleitend geschaltet, zu werden. Das Verfahren weist den Schritt auf, dass eine erste Ansteuerspannung an das erste Schaltmodul zum Abschalten desselben für einen ersten Zeitraum angelegt wird, wobei das Niveau der ersten Ansteuerspannung unterhalb einer vorgegebenen Schwellenspannung liegt, oberhalb derer der erste MOSFET minimal leitend wird. Der erste Zeitraum ist gewählt, damit die erste Inversdiode den Laststrom im Wesentlichen vollständig übernimmt. Das Verfahren weist ferner den anschließenden Schritt auf, dass nach dem ersten Zeitraum eine zweite Ansteuerspannung an das erste MOSFET-Schaltmodul für einen zweiten Zeitraum angelegt wird, um ein Abschaltverhalten der ersten Inversdiode zu beeinflussen. Die zweite Ansteuerspannung weist ein Zwischenniveau auf, das zwischen dem Niveau der ersten Ansteuerspannung und demjenigen der Schwellenspannung des ersten Schaltmoduls liegt. Das Verfahren weist ferner den anschließenden Schritt auf, dass eine dritte Ansteuerspannung an das zweite MOSFET-Schaltmodul zum Einschalten desselben angelegt wird, wobei das Niveau der dritten Ansteuerspannung oberhalb einer vorgegebenen Schwellenspannung liegt, oberhalb derer der zweite MOSFET minimal leitend wird, um eine Kommutierung des Laststroms von der ersten Inversdiode auf den zweiten MOSFET zu bewirken. Das Verfahren weist außerdem darauffolgend auf, dass an das erste Schaltmodul nach dem Ablauf des zweiten Zeitraums eine vierte Ansteuerspannung mit einem Niveau angelegt wird, das unterhalb des Zwischenniveaus der zweiten Ansteuerspannung liegt, um das erste Schaltmodul zu sperren bzw. im Sperrzustand zu halten.

Die Erfindung beruht auf der Erkenntnis, dass das Abschaltverhalten eines MOSFET-Schaltmoduls im Zusammenhang mit seiner Inversdiode durch eine gezielte Ansteuerung des MOSFET, insbesondere eine geeignete Wahl der Höhe und des Verlaufs der Ansteuerspannung für den Rückwärtsstrombetrieb, also die Stromflussrichtung der Inversdiode, positiv beeinflusst werden kann. Durch Anlegen der ersten Ansteuerspannung wird der erste MOSFET des ersten Schaltmoduls schnell und sicher abgeschaltet, so dass die Gefahr eines Kurzschlusses durch die beiden Schaltmodule, insbesondere eines Brückenkurzschlusses, beim anschließenden Einschalten des zweiten Schaltmoduls beseitigt und eine schnelle Übernahme des Laststroms durch die zugehörige erste Inversdiode erreicht wird. Dies ergibt auch einen schnelleren und sichereren Umschaltvorgang insgesamt im Vergleich zu dem Fall, wenn die Zwischenstufe unmittelbar, ohne die vorherige erste Ansteuerspannung angelegt werden würde.

Die anschließende Zwischenstufe der zweiten Ansteuerspannung mit einem Zwischenniveau, das höher als dasjenige der ersten Ansteuerspannung ist, führt zu einer Reduktion der mit herkömmlichen MOSFET-Bauelementen verbundenen Oszillationen im Zusammenspiel mit der intrinsischen Diode während und nach Umschalttransienten. Das Zwischenniveau der zweiten Ansteuerspannung liegt unterhalb der Schwellenspannung des ersten MOSFETs, vorzugsweise knapp darunter, oberhalb der Nullspannung. Ohne durch eine Theorie gebunden sein zu wollen, wird angenommen, dass durch die vorübergehende Erhöhung der Ansteuerspannung bis in die Nähe der Schwellenspannung der Kanal des MOSFETs derart beeinflusst werden kann, dass der Kanalwiderstand verringert wird und die Ladungsträgerverteilung im Bauelement beeinflusst wird, was das Abschaltverhalten der Inversdiode während des Kommutierungsvorgangs positiv beeinflusst. Die gezielte Ansteuerung des MOSFETs, der dabei nicht eingeschaltet wird (d.h. die Ansteuerspannung ist etwas kleiner als die Schwellenspannung), für den Betrieb mit Rückwärtsstromrichtung ermöglicht es, durch Beeinflussung der ohmschen Charakteristik und der Ladungsträgerverteilung innerhalb des Bauelementes das Abschaltverhalten der Diode zu optimieren. Das Kommutierungsverhalten der Diode wird durch eine gezielte Verringerung des Kanalwiderstands und eine Beeinflussung der Ladungsträgerverteilung in der PIN-Struktur, ohne den MOSFET einzuschalten. Beide Effekte werden durch eine geeignete Ansteuerung in vorteilhafter Weise genutzt. Dadurch können die normalerweise auftretenden Oszillationen, die für die Leistungshalbleiter und bspw. ein Stromrichtersystem von Nachteil oder sogar schädlich sind, wirksam gedämpft und das Schaltverhalten der Diode beeinflusst werden, ohne hierzu den externen Gate-Widerstand erhöhen zu müssen. Für den Betrieb von parallelen MOSFET-Schaltelementen können Oszillationen sowohl innerhalb des Bauteils als auch zwischen parallelen Bauelementen deutlich verringert werden, was für schnellere Kommutierungsvorgänge, wie sie für MOSFET- und insbesondere SiC-MOSFET-Bauelemente typisch sind, von enormer Bedeutung ist.

Nachdem das Abschaltverhalten der ersten Inversdiode vorteilhafterweise beeinflusst worden ist, kann das zweite MOSFET-Schaltmodul durch eine geeignete dritte Ansteuerspannung eingeschaltet werden, und die entsprechend reduzierte vierte Ansteuerspannung kann an das erste Schaltmodul angelegt werden, um eine endgültige, schnelle und vollständige Kommutierung des Laststroms von der ersten Inversdiode auf den zweiten MOSFET zu bewirken. Trotz der eingefügten Zwischenstufe der zweiten Ansteuerspannung können die Schaltzeiten bei der erfindungsgemäßen Schaltfolge sehr gering gehalten werden. Dies ermöglicht Schaltfrequenzen der Schaltmodule im Bereich von einigen Hz bis kHz oder sehr hohe Schaltfrequenzen von vorzugsweise einigen zig oder Hundert kHz. Es sind sogar Schaltfrequenzen im MHz-Bereich für Anwendungen mit geringer Leistung möglich. Das Verfahren macht somit die Verwendung der Schaltmodule für unterschiedliche Applikationen geeignet.

In bevorzugten Ausführungsformen des erfindungsgemäßen Verfahrens wird eine zweite Ansteuerspannung mit einem Zwischenniveau, das zwischen dem Niveau einer ersten Ansteuerspannung zum Abschalten des abkommutierenden Schaltmoduls und dem Niveau der Schwellenspannung des abkommutierenden Schaltmoduls liegt, bei jedem Kommutierungsvorgang von dem ersten Schaltmodul auf das zweite Schaltmodul und umgekehrt sowie stromflussrichtungsunabhängig angewandt. D.h., die zweite Ansteuerspannung mit dem Zwischenniveau wird vor dem Anlegen einer dritten Ansteuerspannung zum vollständigen Einschalten des anderen Schaltmoduls, auf den der Strom kommutiert wird, sowohl dann, wenn das abkommutierende Schaltmodul in Vorwärtsstromflussrichtung betrieben wird, als auch dann angelegt, wenn das abkommutierende Schaltmodul in Rückwärtsstromflussrichtung betrieben wird. Vorteilhafterweise ist dann keine Erfassung der Stromflussrichtung durch die Schaltmodule erforderlich, was die Schaltungs- und Ansteuerungskomplexität verringert.

In alternativen Ausführungsformen wird das Verfahren nur bei Kommutierungsvorgängen angewandt, wenn das abkummutierende Schaltmodul in Rückwärtsstromflussrichtung betrieben wird und das Abschaltverhalten der zugehörigen abkommutierenden Inversdiode verbessert werden kann. D.h., eine zweite Ansteuerspannung mit einem Zwischenniveau, das zwischen dem Niveau einer ersten Ansteuerspannung zum Abschalten des abkommutierenden Schaltmoduls und dem Niveau der Schwellenspannung des abkommutierenden Schaltmoduls liegt, wird bei jedem Kommutierungsvorgang von dem ersten Schaltmodul auf das zweite Schaltmodul und umgekehrt vor dem Anlegen einer dritten Ansteuerspannung zum vollständigen Einschalten des anderen Schaltmoduls nur dann angelegt, wenn der momentane Laststrom in der Rückwärtsflussrichtung durch das abkommutierende Schaltmodul fließt. Hierzu wird die Stromflussrichtung durch die Schaltmodule geeignet erfasst.

Unabhängig von den vorstehend erwähnten Ausführungsformen kann in vorteilhaften Ausführungsformen auch das Einschalten des Schaltmoduls, auf den der Laststrom kommutiert wird, zwei- oder mehrstufig, jedenfalls mit wenigstens einer Zwischenstufe der Ansteuerspannung erfolgen, die unterhalb des Niveaus der dritten Ansteuerspannung zum vollständigen Einschalten des Schaltmoduls und oberhalb der Schwellenspannung liegt. Im Falle eines Kurzschlusses eines Schaltmoduls kann somit das Kurschlussstromniveau mit der verringerten Zwischenstufe der Ansteuerspannung begrenzt werden. Außerdem ermöglicht diese Maßnahme eine Reduktion des Aufwands zur Erkennung eines Kurzschlusses des Bauteils.

Das erste und das zweite Schaltmodul können vorteilhafterweise in einem gemeinsamen Kommutierungskreis angeordnet und über Leitungselemente mittelbar oder unmittelbar leitend miteinander verbunden sein. Sie können vorzugsweise in Reihe unmittelbar miteinander leitend verbunden sein. Es können jedoch auch andere Bauelemente zwischen dem ersten und dem zweiten Schaltmodul eingefügt sein.

In bestimmten Anwendungen bilden das erste und das zweite Schaltmodul eine Halbbrückenschaltung, die an eine Gleichspannungsversorgung, z.B. einen Gleichspannungszwischenkreis eines Stromrichters oder dgl., anschließbar ist. Der Verbindungspunkt zwischen den Schaltmodulen kann einen Brückenabgriff bilden, an den eine Last, insbesondere eine Wechselstrom(AC)-Last, die einen induktiven Anteil aufweist, bspw. eine elektrischen Maschine, ein Elektromotor, etc., angeschlossen werden kann. Es können auch andere Schaltkreise, z.B. Vollbrückenschaltungen, unter Verwendung des erfindungsgemäßen Verfahrens realisiert und betrieben werden.

In bevorzugten Ausführungsformen der Erfindung ist das Verfahren ein Teil eines Steuerungsverfahrens für einen Stromrichter, wobei das erste und das zweite Schaltmodul ein Leistungsmodul bilden, das wenigstens einen Phasenzweig des Stromrichters bildet. Der Stromrichter kann von beliebiger Topologie, insbesondere ein zweistufiger, dreistufiger oder auch mehrstufiger, ein- oder mehrphasiger Stromrichter beliebiger Bauart, wie z.B. NPC-, NPP- oder anderer heutzutage bekannter oder künftige entwickelter Bauart sein. Insbesondere für Stromrichter mit hohen Schaltfrequenzen im kHz-Bereich bis zu einer Leistung von einigen MW oder Anwendungen mit geringer Leistung unterhalb von einem kW im MHz-Bereich ist das Verfahren besonders geeignet. Die reduzierten Oszillationen der kommutierenden Diode verbessern das Schaltverhalten, reduzieren Schaltverluste und verbessern die elektromagnetische Verträglichkeit hinsichtlich der Robustheit und Emission des gesamten Stromrichters.

Der Stromrichter kann eine der Anzahl der Phasen entsprechende Anzahl von Phasenzweigen, vorzugsweise drei Phasenzweige aufweisen, wobei jeder Phasenzweig ein oder mehrere in Reihe und/oder parallel zueinander geschaltete erste Schaltmodule und ein oder mehrere in Reihe und/oder parallel zueinander geschaltete zweite Schaltmodule aufweist. Vorzugsweise ist eine gleiche Anzahl erster und zweiter Schaltmodule zur Schaffung eines symmetrischen Aufbaus des Stromrichters vorhanden. Derartige Stromrichter können vorteilhafterweise für unterschiedliche Anwendungen, einschließlich zur Ansteuerung von Antrieben, zur Energieversorgung und -verteilung, verwendet werden.

In besonders bevorzugten Anwendungen weist jedes Leistungsmodul oder jeder Phasenzweig des Stromrichters zwei oder mehrere parallel zueinander geschaltete erste Schaltmodule und zwei oder mehrere parallel zueinander geschaltete zweite Schaltmodule auf. Die ersten und die zweiten Schaltmodule werden jeweils synchron zueinander geschaltet. Die Parallelschaltung der Schaltmodule ermöglicht eine höhere gesamte Stromtragfähigkeit für entsprechende Anwendungen im hohen Leistungsbereich. Die reduzierten Oszillationen der abkommutierenden Inversdioden reduzieren die Beeinflussung der parallel geschalteten Schaltmodule untereinander und sorgen zusätzlich für eine verbesserte dynamische Stromaufteilung durch eine Vergleichmäßigung des Schaltverhaltens. Prinzipiell genügt eine einzige Gate-Treibereinheit, um mehrere parallel geschaltete Schaltmodule anzusteuern. Bevorzugterweise ist jedem Schaltmodul eine Gate-Treibereinheit zugeordnet, wobei die Gate-Treibereinheiten von einer gemeinsamen Ansteuerungseinheit synchron angesteuert werden.

Das Verfahren gemäß einer beliebigen vorstehend erwähnten Ausführungsform kann ferner ein Empfangen eines Schaltanforderungssignals von einer übergeordneten Steuerung aufweisen, wobei das Anlegen der ersten Ansteuerspannung als Reaktion auf den Empfang des Schaltanforderungssignals erfolgt. Das Schaltanforderungssignal kann bspw. ein Abschaltanforderungssignal sein, das das erste Schaltmodul betrifft. Es ist möglich, dass gesonderte Ein- und Abschaltsignale für das erste und das zweite Schaltmodul durch eine Ansteuerungseinrichtung von der übergeordneten Steuerung empfangen werden, woraufhin das Anlegen der Ansteuerspannungen an die Schaltmodule und deren Zeitsteuerung durch die gemeinsame Ansteuereinrichtung koordiniert werden. Es könnte aber auch nur ein einziges Schaltsignal von der übergeordneten Steuerung an die gemeinsame Ansteuereinrichtung gesandt werden, die dann alle Ansteuerspannungen automatisch in der erforderlichen Zeitabfolge generieren bzw. bewirken könnte.

In dem Verfahren einer beliebigen vorstehend erwähnten Ausführungsformen kann in einem Zeitabschnitt vor dem Anlegen der ersten Ansteuerspannung vorteilhafterweise an dem ersten Schaltmodul eine Ansteuerspannung anliegen bzw. an dieses angelegt werden, die ein Spannungsniveau oberhalb der Schwellenspannung des ersten MOSFETs des ersten Schaltmoduls aufweist, so dass das erste Schaltmodul leitet. Gleichzeitig kann an dem zweiten Schaltmodul eine Ansteuerspannung anliegen bzw. an dieses angelegt werden, die ein Spannungsniveau unterhalb der Schwellenspannung des zweiten MOSFETs des zweiten Schaltmoduls aufweist, so dass das zweite Schaltmodul sperrt.

In jedem beliebigen vorstehend erwähnten Verfahren kann der erste Zeitraum derart im Voraus festgelegt werden, dass die erste Inversdiode unter den angenommenen Betriebsbedingungen wenigstens 90%, vorzugsweise wenigstens 95% des Laststroms von dem ersten MOSFET übernimmt, bevor die zweite Ansteuerspannung mit dem Zwischenniveau angelegt wird.

Zusätzlich oder alternativ kann das Anlegen der dritten Ansteuerspannung an das zweite Schaltmodul während des zweiten Zeitraums erfolgen. Beide Schritte können zeitlich zumindest einander überlappen, um die Schaltzeit zu minimieren.

Insbesondere kann die Zeitabfolge des Verfahrens vorteilhafterweise derart festgelegt werden, dass das Anlegen der dritten Ansteuerspannung an das zweite Schaltmodul innerhalb des zweiten Zeitraums (t₂) erfolgt, und der zweite MOSFET danach wenigstens 90 %, vorzugsweise wenigstens 95 % des Laststroms von der ersten Inversdiode übernimmt, bevor die vierte Ansteuerspannung an das erste Schaltmodul angelegt wird.

Das erfindungsgemäße Verfahren ist insbesondere zur Verwendung mit Siliziumkarbid(SiC)-MOSFETs geeignet, die die Vorteile extrem hoher Schaltgeschwindigkeiten bzw. Schaltfrequenz, hoher maximal zulässiger Sperrschichttemperatur als auch geringer Ansteuer- und Bauteilverlustleistung bieten und eine Basis für ein gutes Betriebsverhalten und einen hohen Wirkungsgrad der Leistungsmodule und daraus gebildeter Stromrichter schaffen. Insofern sind der erste und der zweite MOSFET vorzugsweise SiC-MOSFETS. Unabhängig davon, ob sie auf SiC basieren oder nicht, sind der erste und der zweite MOSFET vorzugsweise vom gleichen Leitungstyp, also entweder n-Kanal- oder p-Kanal-MOSFETs. n-Kanal-SiC-MOSFETs sind wegen ihrer inhärenten Eigenschaften besonders bevorzugt. Prinzipiell sind auch p-Kanal-MOSFETs oder sogar Kombinationen aus n- und p-Typen möglich.

In beispielhaften Ausführungsformen eines beliebigen vorstehend erwähnten Verfahrens kann das Niveau der Ansteuerspannung für das erste oder zweite Schaltmodul im Leitendzustand etwa 15-25 Volt, vorzugsweise etwa 20 Volt, betragen, was auch für das Niveau der dritten Ansteuerspannung gilt, wenn die Schwellenspannung im Bereich von etwa 2 bis 7 Volt liegt. Das Niveau der ersten und vierten Ansteuerspannung kann dann etwa 0 bis -10 Volt, vorzugsweise etwa -5 Volt betragen. Das Zwischenniveau der zweiten Ansteuerspannung kann bei etwa -10 bis +4 Volt, z.B. zwischen -3 und +1 Volt liegen, wenn nur der Kanalwiderstand beeinflusst, ein Leitendzustand des MOSFETs aber vermieden werden soll.

In weiteren Ausführungsformen ist es auch möglich, während des ersten Zeitraums das Niveau der ersten Ansteuerspannung zwischen dem Zwischenspannungsniveau und dem Niveau der vierten Ansteuerspannung, also oberhalb des letzteren, festzusetzen, um das Abschaltverhalten des MOSFETs und das Kommutierungsverhalten der Inversdiode weiter zu beeinflussen.

Gemäß einem noch weiteren Aspekt der Erfindung ist eine Einrichtung zur Steuerung eines Kommutierungsvorgangs eines Laststroms von einem ersten Schaltmodul auf ein zweites Schaltmodul geschaffen, wobei das erste und das zweite Schaltmodul jeweils einen ersten bzw. zweiten MOSFET, der durch eine Gate-Source-Spannung ansteuerbar ist, und eine erste bzw. zweite intrinsische Inversdiode aufweisen. Die Steuerungseinrichtung weist eine Gate-Ansteuerungseinrichtung auf, die mit einer übergeordneten Steuerung kommunikationsmäßig verbunden ist, um binäre Schaltanforderungssignale von dieser zu erhalten. Die Gate-Ansteuerungseinrichtung ist ferner eingerichtet, um ein Verfahren, wie vorstehend beschrieben, durchzuführen. Hinsichtlich unterschiedlicher Ausführungsformen, Effekte und Vorteile der Steuerungseinrichtung wird auf die vorstehende Beschreibung des erfindungsgemäßen Verfahrens verwiesen, die hier entsprechend gelten.

Zur Implementierung des erfindungsgemäßen Verfahrens weist die Steuerungseinrichtung vorzugsweise wenigstens eine Gate-Treibereinheit auf, die in der Lage ist, wenigstens drei unterschiedliche Spannungsniveaus zur Ansteuerung des oder der zugehörigen Schaltmodule zu generieren, wobei zu den Spannungsniveaus die Niveaus der ersten, zweiten und dritten Ansteuerspannung gehören.

In einer besonders bevorzugten Implementierung der erfindungsgemäßen Steuerungseinrichtung und des erfindungsgemäßen Verfahrens kann die wenigstens eine Gate-Treibereinheit einen ersten ansteuerbaren Schalter, der einerseits mit einem positiven Spannungspotential und andererseits über einen Einschaltwiderstand mit einem Gate des ersten bzw. zweiten Schaltmoduls verbunden ist, und einen zweiten ansteuerbaren Schalter aufweisen, der einerseits mit einem negativen Spannungspotential und andererseits über einen Ausschaltwiderstand mit demselben Gate des ersten bzw. zweiten Schaltmoduls verbunden ist. Die Spannungspotentiale, der Einschaltwiderstand und der Ausschaltwiderstand können vorteilhafterweise derart bemessen sein, dass, wenn beide Schalter gleichzeitig eingeschaltet werden, das Zwischenniveau der zweiten Ansteuerspannung an das Gate des ersten bzw. zweiten Schaltmoduls angelegt wird und unterhalb, vorzugsweise im Bereich der Schwellenspannung des MOSFETs liegt, womit das Verfahren vorteilhafter Weise ohne komplexere Treiberstufen aufgebaut werden kann.

Weitere vorteilhafte Einzelheiten von Ausführungsformen der Erfindung ergeben sich aus den Unteransprüchen, der Zeichnung sowie der zugehörigen Beschreibung. Die Erfindung ist nachstehend anhand einer Zeichnung näher beschrieben, die beispielhafte, keinesfalls beschränkende Ausführungsformen der Erfindung zeigt, wobei gleiche Bezugszeichen in allen Figuren verwendet werden, um gleiche Elemente zu bezeichnen. Es zeigen:
Fig. 1 eine schematische Darstellung eines Leistungsmoduls mit zu einer Halbbrücke geschalteten Schaltmodulen gemäß einer Ausführungsform der vorliegenden Erfindung, in stark vereinfachter Prinzipdarstellung;
Fig. 2 ein Verfahren zur Ansteuerung der Schaltmodule des Leistungsmoduls nach Fig. 1 gemäß einer Ausführungsform der Erfindung;
Fig. 3 Zeitdiagramme, die die Ansteuerungssignale bei der Durchführung des Verfahrens nach Fig. 2 veranschaulichen;
Fig. 4 die zeitlichen Verläufe (a) der Spannungen und Ströme an einem der Schaltmodule bei Abschaltung desselben ohne (gestrichelte Linie) und mit (durchgezogene Linie) Durchführung des erfindungsgemäßen Verfahrens und (b) die resultierenden Leistungsflüsse;
Fig. 5 ein für eine höhere Stromtragfähigkeit ausgelegtes Leistungsmodul gemäß einer modifizierten Ausführungsform der Erfindung in stark vereinfachter schematisierter Darstellung;
Fig. 6 eine Ausführungsform einer Gate-Treibereinheit zur Ansteuerung von Schaltmodulen bei der Durchführung des erfindungsgemäßen Verfahrens; und
Fig. 7 eine weitere Ausführungsform einer Gate-Treibereinheit zur Ansteuerung von Schaltmodulen bei der Durchführung des erfindungsgemäßen Verfahrens, in vereinfachter Darstellung.

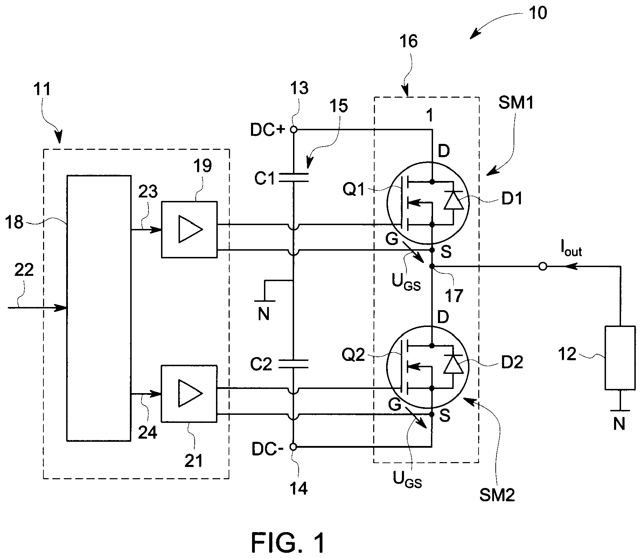

In Fig. 1 ist in einer stark vereinfachten schematischen Darstellung ein beispielhaftes Leistungsmodul 10 gemäß einer Ausführungsform der vorliegenden Erfindung veranschaulicht. Das Leistungsmodul 10 weist zwei Schaltmodule SM1 und SM2 auf, die durch eine Ansteuerungseinrichtung 11 gesteuert geschaltet werden, um Leistung von einer Gleichspannungsenergieversorgung (DC+/DC-) zu einer Last 12 in einer gesteuerten Weise zu liefern. Wie ohne Weiteres erkennbar, bilden die Schaltmodule SM1 und SM2 eine Halbbrücke, indem sie in Reihe miteinander verbunden und zwischen dem positiven Anschluss 13 und dem negativen Anschluss 14 der hier nicht dargestellten Gleichspannungsversorgung angeschlossen sind.

Die Gleichspannungsversorgung kann auch ein Gleichspannungszwischenkreis eines Umrichters und die an den Anschlüssen 13, 14 anliegende Gleichspannung U_{DC} durch Gleichrichtung aus einer Wechselspannung gewonnen sein. Bspw. ist in Fig. 1 eine Ausführungsform mit einem Gleichspannungszwischenkreis 15 veranschaulicht, der durch zwei in Reihe verbundene Zwischenkreiskondensatoren C1, C2 gebildet ist, die zwischen den Gleichspannungsanschlüssen 13, 14 angeschlossen sind und deren Verbindungspunkt mit einem lokalen Bezugspunkt N verbunden ist. Vorzugsweise haben die Kondensatoren C1, C2 gleiche Kapazitäten, so dass über den Kondensatoren C1, C2 im Wesentlichen die gleiche Spannung abfällt, die jeweils der halben Gleichspannung U_{DC} entspricht.

Jedes einzelne der Schaltmodule SM1 und SM2 weist wenigstens einen ersten Transistor Q parallel zu einer Diode D auf. Insbesondere weist das erste Schaltmodul SM1 einen ersten Transistor Q1 antiparallel zu einer ersten Diode D1 auf, während das zweite Schaltmodul SM2 einen zweiten Transistor Q2 antiparallel zu einer zweiten Diode D2 aufweist. Wenngleich hier das obere Schaltmodul SM1 der Halbbrücke 6 mit dem Transistor Q1 und der Diode D1 als "erste" bezeichnet werden und für das untere Schaltmodul SM2 mit dem Transistor Q2 und der Diode D2 die Bezeichnung "zweite" verwendet wird, dient dies lediglich dazu, die beiden Schaltmodule voneinander zu unterscheiden, und es soll keine Reihenfolge oder Wichtigkeit angeben. Die Ausdrücke "erste" und "zweite" für die Schaltmodule SM1 und SM2 und deren Komponenten könnten auch gegeneinander vertauscht werden.

In der dargestellten Ausführungsform sind der erste Transistor Q1 und der zweite Transistor Q2 Metall-Oxid-Halbleiter-Feldeffekttransistoren (MOSFETs). Unter der Bezeichnung MOSFET sollen hierin alle Feldeffekttransistoren mit isoliertem Gate, die auch als IGFET bezeichnet werden, verstanden werden, unabhängig davon, ob das Gate-Material ein Metall oder ein anderes Material, wie bspw. dotiertes Polysilizium, Germaniumnitrid oder dgl., ist. Insofern wird für den Transistor Q1 bzw. Q2 allgemein die Bezeichnung MOSFET oder MOSFET-Struktur verwendet. Die Schaltmodule SM1, SM2 sind jedenfalls unipolare Bauelemente, die bei der Stromführung nur die Majoritätsträger, also entweder Elektronen oder Defektelektronen bzw. Löcher, nutzen. Im Gegensatz zu bspw. Bipolartransistoren mit isoliertem Gate (IGBTs), bei denen die bipolaren Eigenschaften, Speicherladungen und der Tailstrom zu vergleichsweise längeren Schaltzeiten führt, ist dieser Effekt bei unipolaren Halbleiterbauelementen weitgehend beseitigt, so dass sich deutlich höhere Schaltfrequenzen realisieren lassen. Das Leistungsmodul 10 mit den MOSFET-Schaltmodulen SM1 und SM2, wie in Fig. 1 veranschaulicht, lässt sich auch für äußerst hohe Schaltfrequenzen im kHz-Bereich, von einigen zig oder Hundert kHz, oder sogar im MHz-Bereich anwenden. Besonders bevorzugt sind die Schaltmodule SM1, SM2 auf Basis von Siliziumkarbid (SiC) hergestellt. SiC-MOSFETs weisen beträchtliche Vorteile in Bezug auf extrem hohe Schaltfrequenzen, eine hohe maximal zulässige Sperrschichttemperatur und eine geringe Ansteuer- und Bauteilverlustleistung auf. Sie ermöglichen ein gutes Betriebsverhalten und einen hohen Wirkungsgrad der daraus gebildeten Leistungsmodule. Es könnten aber auch MOSFETs auf Basis von Silizium, bspw. dotiertem Polysilizium, verwendet werden.

Wie ferner aus Fig. 1 ersichtlich, sind die hier verwendeten MOSFETs Q1, Q2 vom n-Kanal-Typ. n-Kanal-MOSFETs sind hinsichtlich ihrer Eigenschaften p-Kanal-MOSFETs überlegen und ermöglichen eine einfachere Beschaltung und Ansteuerung. Es könnten aber auch p-Kanal-MOSFETs hierin verwendet werden.

Die Dioden D1 und D2 sind interne Körperdioden des jeweiligen Transistors Q1 bzw. Q2. Wie für Fachleute auf dem Gebiet allgemein bekannt, bildet der MOSFET eine doppelt diffundierte Struktur, die einen p-n-Übergang zwischen Source und Drain umfasst. Dieser Übergang wird leitend, wenn der MOSFET in Rückwärtsrichtung betrieben wird, bei einem n-Kanal-MOSFET bspw. z.B. dann, wenn an Source eine höhere Spannung angelegt wird als an Drain. Da dies die umgekehrte Richtung im Vergleich zu dem normalen Betrieb ist, wird dieser intrinsische p-n-Übergang auch als Inversdiode bezeichnet. Unter Verwendung der intrinsischen Inversdiode der MOSFETs Q1, Q2 kann ein Betrieb sowohl in Vorwärts- als auch in Rückwärtsrichtung erfolgen, wobei im Vergleich zu diskreten Dioden, die zu diesem Zweck bspw. einem IGBT antiparallel zugeschaltet werden, Platz und Kosten in dem Leistungsmodul 10 deutlich eingespart werden können.

Zurückkehrend zu Fig. 1, ist ein Drain-Anschluss D des ersten MOSFETs Q1 mit dem positiven Anschluss 13 der Gleichspannungsversorgung verbunden, während sein Source-Anschluss S mit dem Drain-Anschluss D des zweiten MOSFETs Q2 verbunden ist. Der Source-Anschluss S des zweiten MOSFETs Q2 ist mit dem negativen Anschluss 4 der Gleichspannungsversorgung verbunden. Die Gate- und Source-Anschlüsse G, S der Transistoren Q1, Q2 sind ferner mit der Ansteuerungseinrichtung 11 gekoppelt.

Der Verbindungspunkt zwischen den beiden Schaltmodulen SM1 und SM2 bildet einen Brückenabgriff 17, an den die Last 12 angeschlossen ist. Insbesondere ist die Last 12 zwischen dem Brückenabgriff 17 und hier dem lokalen Bezugspunkt N angeschlossen. Die Last 12 ist eine Wechselspannungs- oder Wechselstromlast (AC-Last), wie bspw. eine elektrische Maschine, die durch das Leistungsmodul 10 mit Leistung versorgt wird. Im Allgemeinen weist die Last 12 sowohl einen ohmschen als auch einen induktiven Anteil auf.

Zur Ansteuerung des Leistungsmoduls 10 dient die Ansteuerungseinrichtung 11, die eine Auswerte- und Steuereinheit 18 und Gate-Treibereinheiten 19, 21 aufweist. Die Auswerte- und Steuereinheit 18 ist mit einer hier nicht näher dargestellten übergeordneten Steuerung kommunikationsmäßig verbunden und dazu eingerichtet, ein von der übergeordneten Steuerung empfangenes Schaltanforderungssignal 22 zum Ein- und Abschalten der Schaltmodule SM1, SM2 zu empfangen und die Gate-Treibereinheiten 19, 21 als Reaktion auf das Schaltanforderungssignal 22 in einer koordinierten Weise zu steuern, um die Ein- und Abschaltung der Schaltmodule SM1, SM2 in gesteuerter Weise zu bewirken. Die Gate-Treibereinheiten 19, 21 sind jeweils mit dem Gate- und dem Source-Anschluss G, S des ersten bzw. zweiten MOSFETs Q1 bzw. Q2 verbunden und dazu eingerichtet, durch Anlegen einer geeigneten Gate-Source-Ansteuerspannung U_{GS} den jeweiligen MOSFETs Q1 bzw. Q2 einzuschalten, so dass dieser leitend wird, bzw. abzuschalten, so dass dieser nicht leitet bzw. sperrt. Wie allgemein bekannt, können die MOSFETs Q1 bzw. Q2 eingeschaltet werden, wenn die Spannung U_{GS} größer als eine spezifische Schwellenspannung U_{TH} ist, während bei einer Gate-Source-Ansteuerspannung U_{GS} unterhalb der Schwellenspannung U_{TH} der jeweilige MOSFET abgeschaltet wird. Wie in größeren Einzelheiten nachstehend erläutert, sind die Gate-Treibereinheiten 19, 21 hier dazu eingerichtet, Ansteuerspannungen U_{GS} auf unterschiedlichen Niveaus, einschließlich einer Spannung oberhalb der Schwellenspannung U_{TH}, einer zweiten Ansteuerspannung in der Nähe und unterhalb der Schwellenspannung und einer dritten Ansteuerspannung deutlich unterhalb der Schwellenspannung, zu generieren und an die Transistoren Q1, Q2 anzulegen. In bekannter Weise ist zur Ein- und Abschaltung von MOSFETs bis auf einen Strom zur Umladung parasitärer Kapazitäten und der Gatekapazität kein wesentlicher Ansteuerungsstrom erforderlich, so dass die Gate-Treibereinheiten 19, 21 vorteilhafterweise keine wesentliche Stromaufnahmefähigkeit aufweisen müssen. Die Gate-Treibereinheiten 19, 21 sind beide mit der Auswerte- und Steuereinheit 18 kommunikationsmäßig verbunden, um Steuersignale 23, 24 von dieser zu empfangen und daraufhin den jeweiligen Transistor Q1 bzw. Q2 zu schalten.

Im Betrieb steuert die Ansteuerungseinrichtung 11 das erste Schaltmodul SM1 und das zweite Schaltmodul SM2 in einer modulierten Weise mit hohen Schaltfrequenzen von z.B. mehreren oder einigen zig kHz an, um bspw. ausgehend von der Versorgungsgleichspannung an den DC-Anschlüssen 13, 14 eine Wechselspannung und einen Wechselstrom mit der gewünschten Frequenz von z.B. 50 oder 60 Hz an dem Ausgangsanschluss 17 zur Speisung der Last 12 zu erzeugen. Es sollte verstanden werden, dass das Leistungsmodul 10 auch im umgekehrten Sinne, zur Spannungsgleichrichtung mit einem Energiefluss von dem AC-Anschluss 17 zu den DC-Anschlüssen 13, 14 betrieben werden kann und die Ausführungen entsprechend gelten. Jedenfalls betreibt die Ansteuerungseinrichtung 11 die Schaltmodule SM1, SM2 in einer komplementären Weise derart, dass, wenn das erste Schaltmodul SM1 gerade leitet, das zweite Schaltmodul SM2 gerade sperrt, und umgekehrt. Ein Betrieb, in dem beide Schaltmodule SM1, SM2 gleichzeitig durchleiten, sollte vermieden werden, weil dies zu einem Kurzschluss der an die Leistungsversorgungsanschlüsse 13, 14 angeschlossenen Gleichspannungsversorgung führen würde.

Wenn das erste Schaltmodul SM1 leitet, während das zweite Schaltmodul SM2 gerade sperrt, ist der Brückenabgriff 17 mit dem positiven Leistungsversorgungsanschluss (DC+) 13 verbunden, wodurch eine positive Versorgungsspannung an der Last 12 bereitgestellt wird. Ein Strom fließt bspw. während einer positiven Halbwelle der ausgangsseitigen Wechselspannung von dem positiven Leistungsversorgungsanschluss 13 durch den ersten MOSFET Q1 und, sofern der Spannungsabfall durch den Laststrom innerhalb des MOSFETs die Schleusenspannung der Diode D1 überschreitet und diese einschaltet, durch die erste Diode D1 in die Last 12 hinein.

Wenn anschließend das Schaltmodul SM1 abgeschaltet wird, während das zweite Schaltmodul SM2 weiterhin sperrt, erhält die induktive Last 12 den Stromfluss aufrecht. Dabei wird dieser Stromfluss zunächst durch die intrinsische erste Inversdiode D1 des ersten Schaltmoduls SM1 ermöglicht, die bei abgeschaltetem ersten MOSFET Q1 den Strom in Rückwärtsflussrichtung des Schaltmoduls SM1 leitet, sobald deren Vorwärtsspannung die Durchlassspannung überschreitet.

Wenn anschließend das zweite Schaltmodul SM2 leitend geschaltet wird, wird der Brückenabgriff 17 an den negativen Leistungsversorgungsanschluss (DC-) 14 gekoppelt, der in einigen Ausführungsformen auch mit der Masse verbunden sein kann. Sobald die Flussspannung der Inversdiode D1 des ersten Schaltmoduls SM1 die Durchlassspannung unterschreitet, sperrt die Inversdiode D1, und der Strom kommutiert von dieser auf den zweiten MOSFET Q2 des zweiten Schaltmoduls SM2.

Wird danach das zweite Schaltmodul SM2 abgeschaltet und daraufhin das erste Schaltmodul SM1 wieder eingeschaltet, so kehren sich die Verhältnisse um, so dass der Stromfluss letztendlich wieder von dem leitenden ersten Schaltmodul SM1 übernommen wird, während das zweite Schaltmodul SM2 sperrt. Die Vorgänge wiederholen sich.

Bei dem Übergang, wenn das erste Schaltmodul SM1 abgeschaltet und der Laststrom positiv ist und das zweite Schaltmodul SM2 eingeschaltet wird, muss der durch die interne Inversdiode D1 des ersten Schaltmoduls SM1 fließende Strom auf den MOSFET Q2 des zweiten Schaltmoduls SM2 kommutiert werden. (Die nachfolgenden Ausführungen gelten gleichermaßen für den Übergang, wenn der Strom von der Inversdiode D2 des zweiten Schaltmoduls SM2 auf den MOSFET Q1 des ersten Schaltmoduls SM1 kommutiert.) Wenn die Inversdiode D1 (bzw. D2) abgeschaltet wird, weil die Vorwärtsspannung der Diode die Durchlassspannung unterschreitet, neigt die intrinsische Inversdiode eines MOSFETs aufgrund des nicht optimierten Abschaltverhaltens, parasitärer Kapazitäten und Induktivitäten dazu zu oszillieren. Es können beträchtliche Oszillationen der Spannung über der Inversdiode und des Diodenstroms mit erheblichen Überspannungen und Stromspitzen und mit sehr hohen Änderungsgeschwindigkeiten (du/dt, di/dt) hervorgerufen werden.

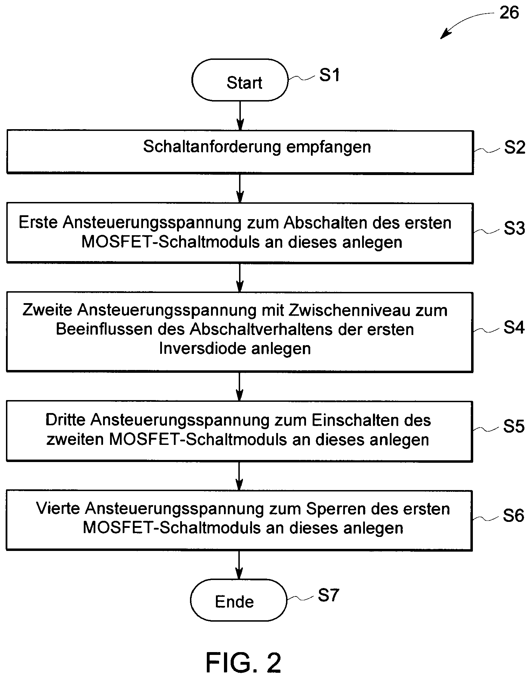

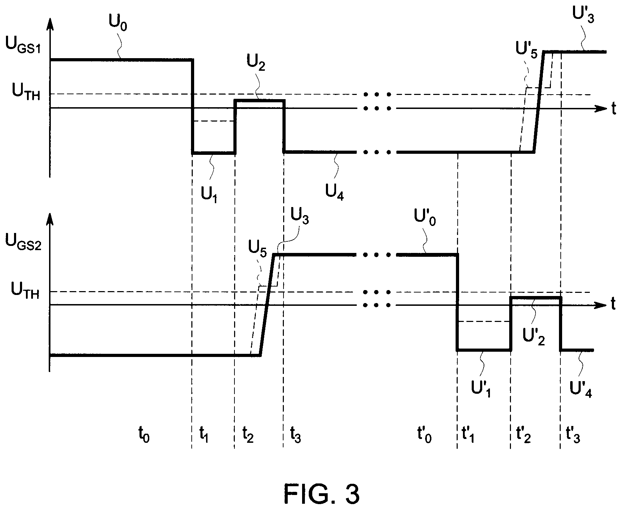

Um dies zu verhindern, ist erfindungsgemäß ein Verfahren zur Steuerung des Kommutierungsvorgangs eines Laststroms von einem der Schaltmodule SM1 bzw. SM2 auf das andere Schaltmodul SM2 bzw. SM1 geschaffen, wodurch derartige Oszillationen während des Kommutierungsvorgangs zumindest deutlich reduziert werden können. Das erfindungsgemäße Verfahren ist nachstehend im Zusammenhang mit den Figuren 2 und 3 näher erläutert.

Fig. 2 zeigt ein Flussdiagramm eines erfindungsgemäßen Verfahrens 26 zur Kommutierung eines Laststroms von einem ersten MOSFET-Schaltmodul, bspw. SM1 in Fig. 1, auf ein zweites MOSFET-Schaltmodul, bspw. SM2 in Fig. 1. Beispielhafte Zeitverläufe geeigneter Gate-Source-Ansteuerspannungen U_{GS1} und U_{GS2}, die in dem Verfahren 26 angewandt werden können, sind in stark vereinfachter Weise in Fig. 3 dargestellt. Das Verfahren 26 beginnt im Schritt S1, wonach im Schritt S2 eine Schaltanforderung von einer übergeordneten Steuerung empfangen wird. Die Schaltanforderung kann bspw. das Schaltanforderungssignal 22 in Fig. 1 sein. Dieses kann ein binäres Signal sein, das bspw. anzeigt, ob das obere Schaltmoduls SM1 oder das untere SM2 eingeschaltet werden soll. Die Ansteuerungseinrichtung 11 erfasst und wertet das Schaltanforderungssignal 22 aus und steuert die Gate-Treibereinheiten 19, 21, damit diese ihr jeweiliges Schaltmodul SM1 bzw. SM2 mit geeigneter Ansteuerspannung U_{GS1}, U_{GS2} entsprechend einem vorgegebenen Zeitschema beaufschlagen. Es könnten auch unterschiedliche Schaltanforderungssignale 22 zum Einschalten und zum Ausschalten sowie für das erste und das zweite Schaltmodul SM1 und SM2 von der übergeordneten Steuerung an die Ansteuerungseinrichtung 11 übermittelt werden, um den Auswerte- und Steuerungsaufwand in dieser zu reduzieren.

Wie aus Fig. 3 ersichtlich, weist die Gate-Source-Ansteuerspannung U_{GS1}, die durch die Gate-Treibereinheit 19 an den ersten MOSFET Q1 angelegt wird, in dem Zeitabschnitt t₀ vor dem Empfang der Schaltanforderung nach Schritt S2 in Fig. 2 ein positives Spannungsniveau U₀ auf, das höher als die Schwellenspannung U_{TH} des MOSFETs ist. Das erste Schaltmodul SM1 ist somit leitend, wobei hier angenommen wird, dass der Laststrom Iₒᵤₜ in der in Fig. 1 angezeigten Richtung in die Schaltungsanordnung hinein und in Rückwärtsflussrichtung durch den ersten MOSFET Q1 fließt. Die Gate-Source-Ansteuerspannung U_{GS2} für den zweiten MOSFET Q2 ist negativ und liegt deutlich unterhalb der Schwellenspannung U_{TH} für den MOSFET Q2, so dass dieser sperrt. Vereinfachend wird angenommen, dass Schaltmodule SM1, SM2 vom gleichen Typ verwendet werden und die Schwellenspannung U_{TH} für beide identisch ist, obwohl dies nicht unbedingt erforderlich ist.

Zurückkehrend zu Fig. 2 wird nach Empfang der Schaltanforderung anschließend im Schritt S3 eine erste Ansteuerspannung U_{GS1} an das erste MOSFET-Schaltmodul SM1 angelegt, um dieses abzuschalten. Wie zusätzlich aus Fig. 3 erkennbar, wird die erste Ansteuerspannung für den ersten Zeitraum t₁ angelegt, wobei das Niveau U₁ der ersten Ansteuerspannung unterhalb der vorgegebenen Schwellenspannung U_{TH} liegt, oberhalb derer der erste MOSFET Q1 minimal leitend wird. Um ein schnelles und sicheres Abschalten des MOSFETs Q1 zu erzielen, wird eine negative Spannung deutlich unterhalb der Schwellenspannung U_{TH} als die Ansteuerspannung gewählt. Der erste MOSFET Q1 schaltet daraufhin ab, während die erste Inversdiode D1 den Laststrom übernimmt. Der erste Zeitraum t₁ ist hinreichend gewählt, damit die Inversdiode D1 den Laststrom weitgehend übernehmen kann. Dies bedeutet, dass die Inversdiode D1 wenigstens 90%, vorzugsweise wenigstens 95% oder mehr des Laststroms übernimmt. Besonders bevorzugt sollte die Inversdiode D1 am Ende des Zeitraums t₁ 100% des Laststroms führen.

Nach Ablauf des Zeitraums t₁ wird gemäß einem Schritt S4 des Verfahrens nach Fig. 2 eine zweite Ansteuerspannung an das erste Schaltmodul SM1 für einen zweiten Zeitraum t₂ angelegt, um ein Abschaltverhalten der ersten Inversdiode D1 für die nachfolgende Kommutierung des Laststroms Iₒᵤₜ auf den zweiten MOSFET Q2 zu beeinflussen. Wie zusätzlich aus Fig. 3 ersichtlich, ist das Niveau U₂ der zweiten Ansteuerspannung zwischen dem Niveau U₁ der ersten Ansteuerspannung und demjenigen der Schwellenspannung U_{TH} gewählt. In dem in Fig. 3 veranschaulichten Beispiel ist das Zwischenniveau U₂ knapp unterhalb der Schwellenspannung U_{TH} gewählt. Das Zwischenniveau U₂ könnte aber auch in etwa der Nullspannung entsprechen.

Es ist festgestellt worden, dass durch das Vorsehen des vorübergehend erhöhten Zwischenniveaus U₂ bei der Ansteuerung des Schaltmoduls SM1 für den Betrieb mit Stromfluss in Diodenflussrichtung das Abschaltverhalten der Diode D1 durch die Beeinflussung der ohmschen Charakteristik und der Ladungsträgerverteilung dieses Bauteils beeinflusst und optimiert werden kann. Insbesondere kann durch das Zwischenniveau der Kanal des MOSFETs Q1 gezielt beeinflusst werden, bevorzugterweise ohne geöffnet zu werden bzw. den MOSFET einzuschalten (U₂ < U_{TH}), um den ohmschen Anteil des Kanalwiderstands während des Kommutierungsvorgans der Diode zu verringern bzw. zu beeinflussen. Es hat sich gezeigt, dass das Zwischenniveau U₂ der zweiten Ansteuerspannung während der Abkommutierung der Diode D1 deren Abschaltvorgang beschleunigt und Oszillationen und Spannungsspitzen an der Diode D1 und des Stroms durch diese deutlich verringern werden kann. Dies hat einen schnelleren Kommutierungsvorgang zur Folge, was insbesondere für hier vorgesehene Anwendungen mit hochfrequent getakteten SiC-Leistungshalbleitern von enormer Bedeutung ist.

Um die Kommutierung des Laststroms von der Diode D1 des ersten Schaltmoduls SM1 auf den MOSFET Q2 des zweiten Schaltmoduls SM2 letztendlich zu bewirken, wird im Schritt S5 eine dritte Ansteuerspannung an das zweite Schaltmodul SM2 angelegt, um den MOSFET Q2 einzuschalten. Das Niveau U₃ der dritten Ansteuerspannung liegt oberhalb der Schwellenspannung U_{TH}, oberhalb derer der zweite MOSFET Q2 minimal leitend wird. Dies ist in Fig. 3 durch die Anstiegsflanke der Spannung U_{GS2} in der unteren Hälfte der Darstellung veranschaulicht. Wie ferner daraus erkennbar, erfolgt das Anwenden des Zwischenniveaus U₂ an dem ersten Schaltmodul SM1 (Schritt S4) und das Einschalten des zweiten Schaltmoduls SM2 (Schritt S5) in einer derart zeitlich koordinierten Weise, dass der MOSFET Q2 des zweiten Schaltmoduls SM2 in dem zweitem Zeitraum t2 wenigstens nahezu vollständig durchschalten kann. Das heißt, der Zeitraum, innerhalb dessen die dritte Ansteuerspannung U₃ angelegt wird, bis der MOSFET Q2 des zweiten Schaltmoduls SM2 vollständig leitend wird, ist vollständig innerhalb des zweiten Zeitraums t₂ enthalten oder überlappt diesen zumindest in wesentlichem Maße. In dem hierin verwendeten Sinne soll verstanden werden, dass ein MOSFET Q1 bzw. Q2 vollständig leitet, wenn er wenigstens 90%, vorzugsweise wenigstens 95% oder mehr, des Stroms führt.

Ist dies nach Ablauf des zweiten Zeitraums t₂ sichergestellt, wird anschließend im Schritt S6 des Verfahrens 26 nach Fig. 2 eine vierte Ansteuerspannung U_{GS1} an das erste MOSFET-Schaltmodul SM1 angelegt, um dieses vollständig zu sperren bzw. im Sperrzustand zu halten. Dies ist in Fig. 3 in dem dritten Zeitraum t₃ dargestellt, in dem die Ansteuerspannung für das erste Schaltmodul SM1 wieder ein negatives Niveau U₄ einnimmt, das in etwa gleich dem Niveau U₁ der ersten Ansteuerspannung ist und bei dem das Schaltmoduls SM1 sicher sperrt. Die Ansteuerspannung U_{GS2} des zweiten Schaltmoduls SM2 ist weiterhin positiv und höher als die Schwellenspannung U_{TH}, um den zweiten MOSFET Q2 im Leitendzustand zu halten. Das Verfahren endet anschließend im Schritt S7.

Wenn im umgekehrten Fall, bei einem aus der Schaltanordnung heraus fließenden Laststrom (entgegen der in Fig. 1 dargestellten Stromrichtung des Stroms Iₒᵤₜ) das zweite Schaltmodul SM2 den Strom in Diodenflussrichtung führt und es nach einer entsprechenden Schaltanforderung abgeschaltet und das erste Schaltmodul SM1 eingeschaltet werden soll, kann die Kommutierung von der Diode D2 des zweiten Schaltmoduls SM2 auf den MOSFET Q1 des ersten Schaltmoduls SM1 in gleicher Weise gemäß dem Verfahren nach Fig. 2 in Verbindung mit entsprechenden Ansteuerspannungen U_{GS1} und U_{GS2} durchgeführt werden, wobei letztere für die beiden Schaltmodule SM1 und SM2 entsprechend vertauscht werden. Dies ist im rechten Teil der Fig. 3 veranschaulicht, wobei die Ansteuerspannungen und Zeiträume zur Unterscheidung mit Apostrophen versehen sind. Ansonsten gelten die vorstehenden Ausführungen zur Durchführung des Verfahrens hier entsprechend.

Die vorstehend erläuterte Schaltfolge mit der Zwischenstufe U₂ bzw. U₂' nach Fig. 2 kann bspw. nur in jeweiligen Rückwärtsleitbetriebsphasen (in Diodenflussrichtung) der Schaltmodule SM1, SM2 angewandt werden, um das Abschaltverhalten der jeweiligen Inversdiode D1 bzw. D2 des einen Schaltmoduls SM1 bzw. SM2 bei der Stromkommutierung auf den MOSFET Q2 bzw. Q1 des anderen Schaltmoduls SM2 bzw. SM1 zu beeinflussen und zu verbessern. Dies erfordert aber entsprechende Maßnahmen zur Erfassung der Stromflussrichtung durch die Schaltmodule.

In bevorzugten Ausführungsformen kann das Verfahren vorteilhafterweise unabhängig von der Stromrichtung, d.h. bei jedem Stromkommutierungsvorgang von SM1 auf SM2 und umgekehrt sowie sowohl im Vorwärts- als auch im Rückwärtsleitbetrieb des abkommutierenden Schaltmoduls SM1 bzw. SM2, eingesetzt werden. Der entsprechende Erfolg der vorteilhaften Beeinflussung des Abschaltvorgangs einer Inversdiode stellt sich dann nur ein, wenn der Strom von einer Inversdiode D1 bzw. D2 eines Schaltmoduls SM1 bzw. SM2 auf den MOSFET Q2 bzw. Q1 des anderen Schaltmoduls SM2 bzw. SM1 kommutiert wird. Dieser Fall tritt im Mittel etwa zu 50% ein, wenn die Schaltmodule SM1 und SM2 abwechselnd ein- und ausgeschaltet. Vorteilhafterweise ist dann aber eine Stromrichtungsdetektion entbehrlich und kann weggelassen werden. Für den Fall, dass die Kommutierung des Stroms aus dem Vorwärtsbetrieb von dem einen MOSFET Q1 bzw. Q2 auf die andere Inversdiode D2 bzw. D1 erfolgt, stellt das Zwischenniveau U₂ bzw. U₂' unterhalb der Schwellenspannung (d.h., U_{GS} < U_{TH}) sicher, dass während der Kommutierung kein Brückenkurzschluss erzeugt werden kann.

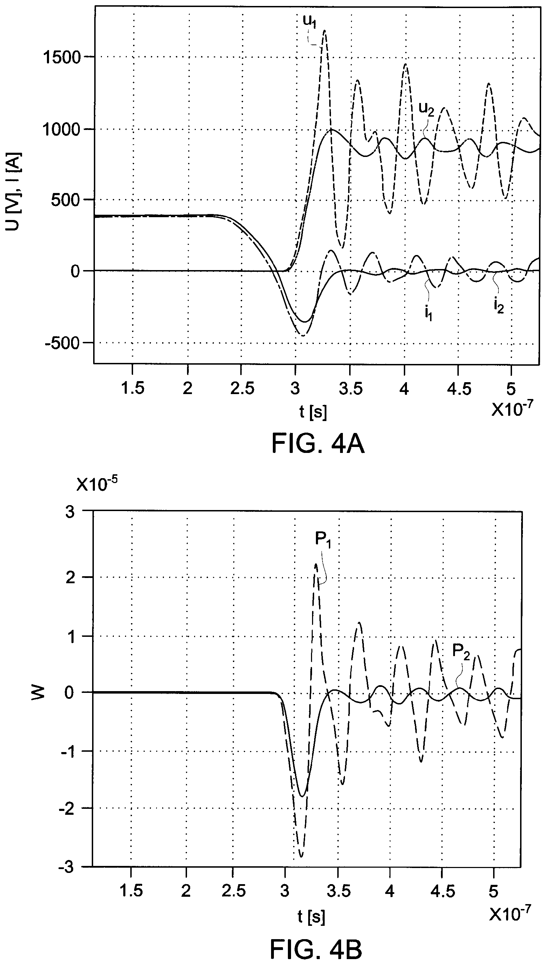

Wie bereits erwähnt, kann die gezielte Beeinflussung des Kanalwiderstandes und der im Bauteil vorliegenden Ladungsträgerverteilung eines MOSFETs Q1 bzw. Q2 eines Schaltmoduls SM1 bzw. SM2 zur Verringerung des Kanalwiderstandes und zur Vermeidung eines Rückstromabrisses der Inversdiode, ohne den Kanal zu öffnen (d.h., U_{GS} < U_{TH}), das Kommutierungsverhalten der Diode D1 bzw. D2 verbessern und Oszillationen innerhalb des Bauelements dämpfen und verringern. Neben dem ohmschen Anteil des Kanalwiderstandes sorgt zusätzlich eine Übernahme des Stroms von der Diode durch die hierzu parallele MOSFET-Struktur Q1 während des Kommutierungsvorgangs der Diode für ein verbessertes Umkehrerholungsverhalten bzw. ein weicheres Abschaltverhalten. Dies ist in Fig. 4 ersichtlich, in der in Fig. 4a beispielhafte zeitliche Verläufe von Spannungen über der Diode D1 bzw. D2 bzw. Strömen durch diese während eines Abkommutierungsvorgangs dargestellt sind. Die Spannungen und Ströme ohne Durchführung des erfindungsgemäßen Verfahrens 26 sind in Fig. 4a mit gestrichelter Linie dargestellt und mit u₁ bzw. i₁ bezeichnet, während diejenigen, die sich bei der Durchführung des erfindungsgemäßen Verfahrens ergeben, mit durchgezogener Linie eingezeichnet und mit u₂ bzw. i₂ bezeichnet sind. Es ist deutlich erkennbar, dass die Oszillationen und Spitzen der Diodenspannung und des Diodenstroms mit dem Verfahren 26 deutlich reduziert werden können. Dies sorgt während des Kommutierungsvorgangs der Inversdiode D1 bzw. D2 für ein verbessertes Umkehrerholungsverhalten bzw. ein weicheres Abschaltverhalten.

Fig. 4b zeigt die sich ergebende Leistung, die im Wesentlichen durch Multiplikation der Spannungen und Ströme der Diode ohne (gestrichelte Linie, P₁) bzw. mit (durchgezogene Linie, P₂) der Durchführung des erfindungsgemäßen Verfahrens 26 erhalten wird. Es sind deutliche Oszillationen der Leistung erkennbar, die mit dem erfindungsgemäßen Verfahren 26 wesentlich reduziert werden können. Diese Oszillationen haben entsprechende Schaltverluste zur Folge, die ebenfalls verringert werden können. Außerdem kann der Kommutierungsvorgang beschleunigt werden, weil die Spannungs- und Stromspitzen schneller auf ein für die vollständige Kommutierung geeignetes, niedriges Niveau reduziert werden können. Durch die verringerte Überspannung an der Inversdiode D1 bzw. D2 ist ein verbessertes Einschalten des MOSFETs möglich, was zu einer Verringerung der Schaltenergie und entsprechender Schaltverluste führt. Durch die verringerte Überspannung können weiterhin höhere Ströme geschaltet werden, bis zu dem Punkt, an dem der sichere Arbeitsbereich des Bauelements oder die gesamte Verlustleistung begrenzend wirkt.

In einer beispielhaften Realisierung mit einem Leistungsmodul 10 mit selbstsperrenden n-Kanal-SiC-MOSFETs kann die Schwellenspannung U_{TH} bspw. in etwa 2-7 Volt betragen, während das Niveau der Ansteuerspannung zum Einschalten der Schaltmodule SM1, SM1, einschließlich der dritten Ansteuerspannung U₃, etwa 15-25 Volt, z.B. etwa 18-20 Volt, das Niveau U₁, U₄ der ersten bzw. vierten Ansteuerspannung zum Abschalten der Schaltmodule SM1, SM2 etwa -3 bis -10 Volt, z.B. etwa -5 Volt, und das Zwischenniveau U₂ der zweiten Ansteuerspannung etwa -10 bis +4 Volt, häufig etwa -3 bis +1 Volt oder in etwa die Schwellenspannung, z.B. etwa +3 Volt, betragen können.

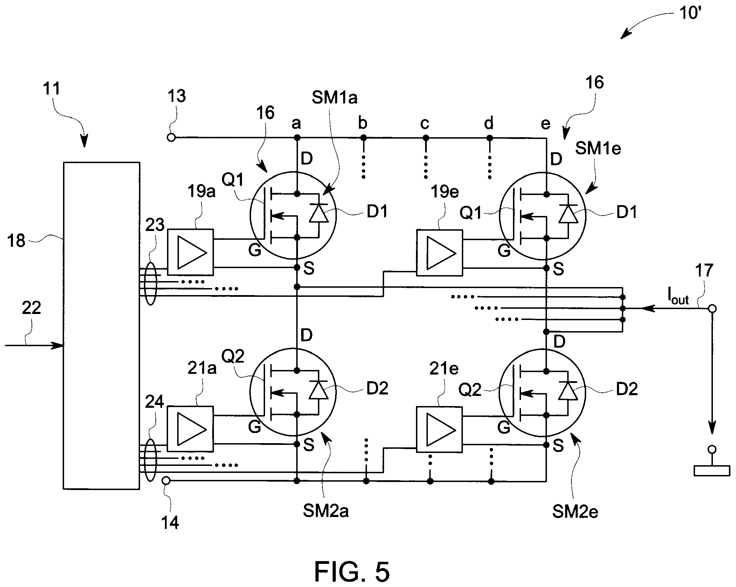

Mit dem erfindungsgemäßen Verfahren können die auf die parasitären Kapazitäten und Induktivitäten der MOSFET-Schaltmodule SM1, SM2 zurückzuführenden Oszillationen nicht nur innerhalb des Bauteils, sondern auch und vor allem zwischen parallelen Bauelementen deutlich verringert werden. Bspw. zeigt Fig. 5 eine Ausführungsform, bei der mehrere Halbbrücken 16a-e parallel zueinander geschaltet sind, um die Stromtragfähigkeit des Leistungsmoduls 10' zu verbessern. Das Leistungsmodul 10' kann einen Phasenzweig eines Stromrichters bilden. Der Übersichtlichkeit und Einfachheit wegen sind in Fig. 5 nur zwei Halbbrücken 16a und 16e dargestellt, wobei angedeutet ist, dass die Einrichtung weitere Parallelzweige b, c, d aufweist, die entsprechende parallel geschaltete Halbbrücken 16b-d aufweisen. Jede Halbbrücke 16a-e ist zwischen dem positiven und dem negativen Gleichspannungsversorgungsanschluss 13, 14 angeschlossen, und die Brückenabgriffe 17a-17e sind miteinander zu einem Ausgangsanschluss 17 verbunden, an den eine Last angeschlossen werden kann. Es ist verständlich, dass mehr oder weniger als fünf Halbbrücken 16a-e vorgesehen sein können.

Zurückkehrend zu Fig. 3 sind darin ferner vorteilhafte Modifikationen des erfindungsgemäßen Verfahrens nach Fig. 2 veranschaulicht. Insbesondere kann das Niveau U₁ der ersten Ansteuerspannung höher als das Niveau U₄ der vierten Ansteuerspannung festgesetzt werden, wie dies in Fig. 3 durch gestrichelte Linien in den Zeiträumen t₁ und t₁' angedeutet ist. Durch Vorsehen einer weiteren Zwischenstufe können das Umschaltverhalten der Schaltmodule SM1, SM2 und das Abschaltverhalten die Inversdiode D1, D2 weiter, wie gewünscht, beeinflusst werden. Darüber hinaus kann auch das Einschalten des Schaltmoduls SM1 bzw. SM2, auf den der Laststrom kommutiert wird, wenigstens zweistufig, mit einer Zwischenstufe U₅ bzw. U₅' der Ansteuerspannung erfolgen, wie dies in Fig. 3 durch gestrichelte Linien in den Zeiträumen t₂ und t₂' angedeutet ist. Die Zwischenstufe U₅ bzw. U₅' sollte unterhalb des Niveaus U₃ bzw. U₃' der dritten Ansteuerspannung zum vollständigen Einschalten des Schaltmoduls SM1 bzw. SM2 und oberhalb der Schwellenspannung U_{TH} liegen. Diese Zwischenstufe ermöglicht es, im Falle eines Kurzschlusses eines Schaltmoduls SM1, SM2 das Kurschlussstromniveau wirksam zu verringern und den schaltungstechnischen Aufwand zur Erkennung eines derartigen Kurzschlusses zu reduzieren.

In Fig. 5 ist ferner die Ansteuerungseinrichtung 11 mit der Auswerte- und Steuereinheit 18 und den Gate-Treibereinheiten 19a-e bzw. 21a-e dargestellt, die den jeweiligen Schaltmodulen SM1a-e bzw. SM2a-e zugeordnet sind. Prinzipiell könnte auch eine gemeinsame Gate-Ansteuereinheit für alle ersten Schaltmodule SM1a-e gemeinsam und eine weitere Gate-Ansteuereinheit für alle zweiten Schaltmodule SM2a-e gemeinsam vorgesehen sein. Jedenfalls werden alle ersten Schaltmodule SM1a-e und alle zweiten Schaltmodule SM2a-e jeweils synchron angesteuert, um gleichzeitig ein- bzw. ausgeschaltet zu werden. Die Funktionsweise ist ansonsten wie bei der in Fig. 1 dargestellten einfachen Halbbrücke 16. Insbesondere wird das erfindungsgemäße Verfahren 26 nach Fig. 2 und 3 auch auf die Ausführungsform nach Fig. 5 angewandt, um den Vorgang der Kommutierung des Laststroms von den intrinsischen Inversdioden D der oberen, ersten Schaltmodule SM1 auf die MOSFETs Q der entsprechenden zweiten Schaltmodule SM2 in dem gemeinsamen Kommutierungskreis oder umgekehrt zu verbessern. Insbesondere bei sich unterscheidenden Kommutierungsinduktivitäten und damit voneinander abweichenden Resonanzfrequenzen der parallel geschalteten Schaltmodule wirkt sich das Verfahren zur Reduktion von Oszillationen äußerst positiv aus. Die reduzierten Oszillationen zwischen den parallelen Bauelementen reduzieren die gegenseitige Störbeeinflussung, sorgen für schnellere Kommutierungsvorgänge, verringern Schaltverluste, verbessern die elektromagnetische Verträglichkeit und das Betriebsverhalten.

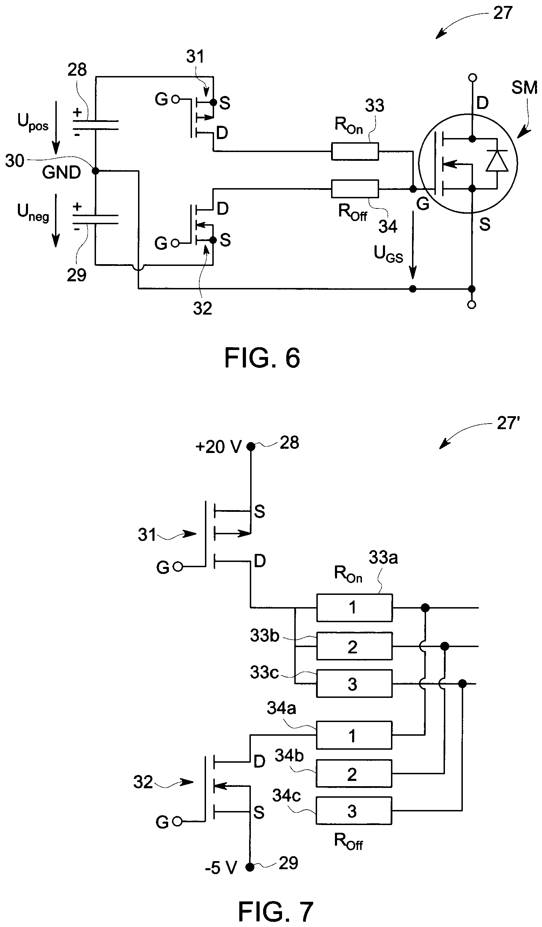

Fig. 6 zeigt eine beispielhafte Schaltungseinrichtung einer Gate-Treibereinheit 27, die als die Gate-Treibereinheit 19, 21 verwendet werden kann. Derartige Gate-Treibereinheiten 27 sind an sich in der Technik bekannt und als solche nicht Gegenstand der Erfindung. Sie können aber bei der Durchführung des erfindungsgemäßen Verfahrens 26 und in der erfindungsgemäßen Ansteuerungseinrichtung 11 vorteilhafterweise genutzt werden.

Die Gate-Treibereinheit 27 der Ausführungsform nach Fig. 6 weist zwei Gleichspannungsquellen 28, 29 auf, die in Reihe miteinander derart verbunden sind, dass der Minuspol der ersten Gleichspannungsquelle 28 mit dem Pluspol der zweiten Gleichspannungsquelle 29 verbunden ist. Dieser Verbindungspunkt 30 liegt vorzugsweise am Bezugspotential der Treibereinheit (GND) und weist ein Nullpotential bezogen auf die Schaltung der Treibereinheit auf. Im Übrigen können die beiden Gleichspannungsquellen 28, 29 unterschiedliche Spannungen Uₚₒₛ bzw. U_{neg} bereitstellen. Der Pluspol der ersten Gleichspannungsquelle 28 ist mit einem Source-Kontakt S eines ersten Schalters 31 verbunden, der als selbstsperrender MOSFET vom p-Kanal-Typ ausgeführt ist. Ein negativer Pol der zweiten Gleichspannungsquelle 29 ist mit dem Source-Anschluss S eines zweiten Schalters 32 verbunden, der als selbstsperrender MOSFET vom n-Kanal-Typ ausgeführt ist. Die Drain-Anschluss D des ersten und zweiten Schalters 31, 32 sind jeweils über einen Einschaltwiderstand 33 (Rₒₙ) und einen Abschaltwiderstand 34 (R_{off}) mit dem Gate-Anschluss G eines Schaltmoduls SM verbunden, dessen Source-Anschluss S mit dem Verbindungspunkt 30 der Gleichspannungsquellen 28, 29 verbunden ist. Das Schaltmodul SM entspricht dem Schaltmodul SM1 bzw. SM2 in Fig. 1 bzw. 5.

Die Gate-Anschlüsse G der Schalter 31, 32 können mit geeigneten Spannungen angesteuert werden, um diese Schalter einzuschalten oder auszuschalten. Ist der erste Schalter 31 eingeschaltet, während der zweite Schalter 32 ausgeschaltet ist, so wird die Spannung Uₚₒₛ der ersten Gleichspannungsquelle 28 über den ersten Schalter 31 und den Einschaltwiderstand 33 an den Gate-Anschluss G des Schaltmoduls SM angelegt. Unter der Annahme, dass diese Spannung oberhalb der Schwellenspannung des Schaltmoduls SM liegt, wird das Schaltmodul SM dadurch ein- bzw. leitend geschaltet.

Ist der erste Schalter 31 ausgeschaltet, und wird der zweite Schalter 32 eingeschaltet, so wird das negative Potential -U_{neg} der zweiten Gleichspannungsquelle 29 über den zweiten Schalter 32 und den Ausschaltwiderstand 34 an die Gate-Elektrode des Schaltmoduls SM angelegt. Nachdem dieses Potential unter dem Nullpotential, jedenfalls unterhalb der Schwellenspannung des Schaltmoduls SM liegt, wird dieses dadurch ausgeschaltet.

Werden sowohl der erste als auch der zweite Schalter 31 und 32 eingeschaltet, so wird die Summenspannung Uₚₒₛ + U_{neg} von der ersten und der zweiten Gleichspannungsquelle 28, 29 über die Schalter 31, 32 und die Widerstände 33, 34 an die Gate-Elektrode G des Schaltmoduls SM angelegt. Das Potential an der Gate-Elektrode G ist unter Vernachlässigung der Durchlassspannungen der Schalter 31, 32 durch die Spannungen Uₚₒₛ, U_{neg} der Gleichspannungsquellen 28, 29 und die Größe der Ein- und Ausschaltwiderstände 33, 34 bestimmt, die hier als Spannungsteiler wirken. Durch geeignete Wahl dieser Größen kann ein beliebiges Potential an das Schaltmodul SM angelegt werden, das dem gewünschten Zwischenniveau U₂ bzw. U₂' der zweiten Ansteuerspannung bei der Durchführung des erfindungsgemäßen Verfahrens 26 nach Fig. 2 und 3 entspricht.

Fig. 7 zeigt als eine Weiterbildung der Gate-Treibereinheit 27 nach Fig. 6 eine weitere Ausführungsform einer Gate-Treibereinheit 27' zur Verwendung bei der Ansteuerung erfindungsgemäßer Leistungsmodule 10 (Fig. 1) bzw. 10' (Fig. 5). Aus Gründen der Vereinfachung sind in Fig. 7 die Spannungsquellen 28, 29 und das Schaltmodul SM nicht explizit dargestellt. Im Unterschied zu der Ausführungsform nach Fig. 6 sind hier an die Drain-Anschlüsse D der Schalter 31, 32 jeweils mehrere Einschaltwiderstände 33a, 33b, 33c und Ausschaltwiderstände 34a, 34b, 34c angeschlossen, die andererseits mit Gate-Anschlüssen von parallel geschalteten Schaltmodulen, bspw. mit den Gate-Anschlüssen der Schaltmodule SM1a-e bzw. SM2a-e der parallel geschalteten Halbbrücken 16a-e in der Ausführungsform nach Fig. 5, verbunden sein können. Es kann eine beliebige Anzahl von parallel geschalteten Schaltmodulen durch eine einzige Gate-Treibereinheit 27' mit einer gemeinsamen Endstufe, die durch die Schalter 31, 32 gebildet ist, und mehreren vorzugsweise gleichen Widerständen 33a-c bzw. 34a-c synchron angesteuert werden.

Das erfindungsgemäße Ansteuerungsverfahren und die erfindungsgemäße Ansteuerungseinrichtung 11 können für unterschiedliche Anwendungen verwendet werden. Vorzugsweise bildet das Leistungsmodul 10 bzw. 10' einen Teil, bspw. einen Phasenzweig eines Stromrichters, der zur Energieversorgung oder -verteilung oder zum Antrieb von elektrischen Maschinen verwendet werden kann. Der Stromrichter kann einen Wechselrichter, einen Gleichrichter oder einen Umrichter bilden. Während in den Figuren 1 und 5 die Kommutierungskreise mit den Schaltmodulen SM1, SM2 in Form von Halbbrücken dargestellt sind, versteht es sich, dass derartige Schaltmodule auch zu anderen Brückenschaltungen, bspw. Vollbrückenschaltungen, reduzierten Vollbrückenschaltungen und dgl., zusammengeschaltet sein können, wie dies auf dem Gebiet der Stromrichter allgemein bekannt ist. Es können auch mehr als zwei Schaltmodule in Reihe miteinander in einem gemeinsamen Phasenzweig eines Stromrichters angeordnet sein. Fernes sind auch andere Anwendungen für die erfindungsgemäßen Leistungsmodule, das erfindungsgemäße Ansteuerungsverfahren und die erfindungsgemäße Ansteuerungseinrichtung möglich. In all solchen Anwendungen ermöglicht es die Erfindung, Oszillationen während Umschaltvorgänge ohne zusätzliche Schaltverluste, wie sie bspw. durch Erhöhung des Gate-Widerstands im Stand der Technik hervorgerufen werden, zu reduzieren, die elektromagnetische Verträglichkeit der Vorrichtungen zu verbessern, die Parallelschaltbarkeit von derartigen Leistungsmodulen und die dynamische Stromaufteilung zu verbessern.

Es sind ein Verfahren und eine Einrichtung zur Steuerung eines Kommutierungsvorgangs eines Laststroms zwischen zwei Schaltmodulen SM1, SM2 offenbart, die jeweils einen MOSFET Q1, Q2, der durch eine Gate-Source-Spannung U_{GS} ansteuerbar ist, und eine intrinsische Inversdiode D1, D2 aufweisen. Um durch parasitäre Schaltkreisparameter und das Abschaltverhalten der Diode hervorgerufene Oszillationen bei der Abkommutierung der Inversdioden D1, D2 zu reduzieren, wird nach Abschaltung eines der Schaltmodule SM1, SM2 die an dieses Schaltmodul SM1, SM2 angelegte Gate-Source-Ansteuerspannung U_{GS1}, U_{GS2} vorübergehend bis in die Nähe der Schwellenspannung U_{TH} zum Einschalten des MOSFETs Q1, Q2 wieder erhöht, bevor und während das andere Schaltmodul SM2, SM1 eingeschaltet wird, um den Strom von der Inversdiode D1, D2 des einen Schaltmoduls SM1, SM2 auf den MOSFET Q2, Q1 des anderen Schaltmoduls SM2, SM1 zu kommutieren.

## Patentansprüche

1. Verfahren zur Steuerung eines Kommutierungsvorgangs eines Laststroms von einem ersten Schaltmodul (SM1) auf ein zweites Schaltmodul (SM2), wobei sowohl das erste als auch das zweite Schaltmodul (SM1, SM2) jeweils einen MOSFET (Q1, Q2), der durch eine Gate-Source-Spannung (U_{GS}) ansteuerbar ist, und eine intrinsische Inversdiode (D1, D2) aufweisen, wobei das Verfahren die aufeinanderfolgenden Schritte aufweist:
Anlegen einer ersten Ansteuerspannung an das erste Schaltmodul (SM1) zum Abschalten desselben für einen ersten Zeitraum (t₁), wobei das Niveau (U₁, U₁') der ersten Ansteuerspannung unterhalb einer vorgegebenen Schwellenspannung (U_{TH}) liegt, oberhalb derer der MOSFET (Q1) des ersten Schaltmoduls (SM1) minimal leitend wird, und wobei der Zeitraum (t₁) gewählt ist, damit die Inversdiode (D1) des ersten Schaltmoduls (SM1) den Laststrom übernimmt;
Anlegen, nach Ablauf des ersten Zeitraums (t₁), einer zweiten Ansteuerspannung an das erste Schaltmodul (SM1) für einen zweiten Zeitraum (t₂), um das Abschaltverhalten der Inversdiode (D1) des ersten Schaltmoduls (SM1) zu beeinflussen, wobei die zweite Ansteuerspannung ein Zwischenniveau (U₂, U₂') aufweist, das zwischen dem Niveau (U₁, U₁') der ersten Ansteuerspannung und demjenigen der Schwellenspannung (U_{TH}) liegt,
Anlegen, innerhalb des zweiten Zeitraums (t₂), einer dritten Ansteuerspannung an das zweite Schaltmodul (SM2) zum Einschalten desselben, wobei das Niveau (U₃, U₃') der dritten Ansteuerspannung oberhalb einer vorgegebenen Schwellenspannung (U_{TH}) liegt, oberhalb derer der MOSFET (Q2) des zweiten Schaltmoduls (SM2) minimal leitend wird, um eine Kommutierung des Laststroms von der Inversdiode (D1) des ersten Schaltmoduls (SM1) auf den MOSFET (Q2) des zweiten Schaltmoduls (SM2) zu bewirken; und Anlegen, nach Ablauf des zweiten Zeitraums (t₂), einer vierten Ansteuerspannung mit einem Niveau (U₄, U₄'), das unterhalb des Zwischenniveaus (U₂, U₂') der zweiten Ansteuerspannung liegt, an den MOSFET des ersten Schaltmoduls (SM1), um dieses zu sperren bzw. im Sperrzustand zu halten.

2. Verfahren nach Anspruch 1, wobei eine zweite Ansteuerspannung mit einem Zwischenniveau (U₂, U₂'), das zwischen dem Niveau (U₁, U₁') einer ersten Ansteuerspannung zum Abschalten des abkommutierenden Schaltmoduls (SM1, SM2) und dem Niveau (U_{TH}) der Schwellenspannung liegt, bei jedem Kommutierungsvorgang von dem ersten Schaltmodul (SM1) auf das zweite Schaltmodul (SM1, SM2) und umgekehrt, unabhängig von der momentanen Stromflussrichtung des Laststroms durch das abkommutierende Schaltmodul (SM1, SM2) vor dem Anlegen einer dritten Ansteuerspannung (U3, U3') zum vollständigen Einschalten des anderen Schaltmoduls (SM1, SM2) angelegt wird.

3. Verfahren nach Anspruch 1, wobei eine zweite Ansteuerspannung mit einem Zwischenniveau (U₂, U₂'), das zwischen dem Niveau (U₁, U₁') einer ersten Ansteuerspannung zum Abschalten des abkommutierenden Schaltmoduls (SM1, SM2) und dem Niveau (U_{TH}) der Schwellenspannung liegt, bei jedem Kommutierungsvorgang von dem ersten Schaltmodul (SM1) auf das zweite Schaltmodul (SM1, SM2) und umgekehrt vor dem Anlegen einer dritten Ansteuerspannung (U₃, U₃') zum vollständigen Einschalten des anderen Schaltmoduls (SM1, SM2) nur dann angelegt wird, wenn der momentane Laststrom in der Rückwärtsflussrichtung durch das abkommutierende Schaltmodul (SM1, SM2) fließt.

4. Verfahren nach einem beliebigen der vorhergehenden Ansprüche, wobei das Einschalten des Schaltmoduls (SM1, SM2), auf den der Laststrom kommutiert wird, wenigstens zweistufig, mit einer Zwischenstufe (U₅, U₅') der Ansteuerspannung erfolgt, die unterhalb des Niveaus (U₃, U₃') der dritten Ansteuerspannung zum vollständigen Einschalten des Schaltmoduls (SM1, SM2) und oberhalb der Schwellenspannung (U_{TH}) liegt.

5. Verfahren nach einem beliebigen der vorhergehenden Ansprüche, wobei das erste und das zweite Schaltmodul (SM1, SM2) in einem gemeinsamen Kommutierungskreis (16) angeordnet und über Leitungselemente vorzugsweise in Reihe unmittelbar leitend miteinander verbunden sind.

6. Verfahren nach Anspruch 5, wobei das erste und das zweite Schaltmodul (SM1, SM2) eine Halbbrückenschaltung (16; 16a-c) bilden, die an eine Gleichspannungsversorgung anschließbar oder angeschlossen ist, und der Verbindungspunkt zwischen Schaltmodulen (SM1, SM2) einen Brückenabgriff (17) zum Anschluss einer Last (12) bildet.

7. Verfahren nach einem beliebigen der vorhergehenden Ansprüche, wobei das erste und das zweite Schaltmodul (SM1, SM2) ein Leistungsmodul (10, 10') bilden, das wenigstens einen Phasenzweig eines Stromrichters bildet.

8. Verfahren nach Anspruch 7, wobei der Stromrichter eine der Anzahl der Phasen entsprechende Anzahl von Phasenzweigen, vorzugsweise drei Phasenzweige aufweist, wobei jeder Phasenzweig ein oder mehrere in Reihe und/oder parallel zueinander geschaltete erste Schaltmodule (SM1a-e) und ein oder mehrere in Reihe und/oder parallel zueinander geschaltete zweite Schaltmodule (SM2a-e) aufweist.

9. Verfahren nach Anspruch 7 oder 8, wobei das Leistungsmodul (10, 10') bzw. jeder Phasenzweig des Stromrichters zwei oder mehrere parallel zueinander geschaltete erste Schaltmodule (SM1a-e) und zwei oder mehrere parallel zueinander geschaltete zweite Schaltmodule (SM2a-e) aufweist, wobei die ersten und die zweiten Schaltmodule (SM1a-e, SM2a-e) jeweils synchron zueinander geschaltet werden.

10. Verfahren nach einem beliebigen der vorhergehenden Ansprüche, wobei die ersten und zweiten Schaltmodule (SM1, SM2; SM1a-e, SM2a-e) mit Schaltfrequenzen von einigen Hz bis kHz, vorzugsweise einigen zig oder Hundert kHz, oder im MHz-Bereich geschaltet werden.

11. Verfahren nach einem beliebigen der vorhergehenden Ansprüche, dass ferner ein Empfangen eines Schaltanforderungssignals (22) von einer übergeordneten Steuerung aufweist, wobei das Anlegen der ersten Ansteuerspannung als Reaktion auf den Empfang des Schaltanforderungssignals (22) erfolgt.

12. Verfahren nach einem beliebigen der vorhergehenden Ansprüche, wobei der erste Zeitraum (t1) derart im Voraus festgelegt wird, dass die Inversdiode (D1) des ersten Schaltmoduls (SM1) unter den angenommenen Betriebsbedingungen wenigstens 90 %, vorzugsweise wenigstens 95 % des Laststroms von dem MOSFET (Q1) des ersten Schaltmoduls (SM1) übernimmt, bevor die zweite Ansteuerspannung angelegt wird.

13. Verfahren nach einem beliebigen der vorhergehenden Ansprüche, wobei das Anlegen der dritten Ansteuerspannung an das zweite Schaltmodul (SM2) während des zweiten Zeitraums (t2) erfolgt.

14. Verfahren nach Anspruch 13, wobei nach Anlegen der dritten Ansteuerspannung an das zweite Schaltmodul (SM2) innerhalb des zweiten Zeitraums (t2) der MOSFET (Q2) des zweiten Schaltmoduls (SM2) wenigstens 90 %, vorzugsweise wenigstens 95 % des Laststroms von der Inversdiode (D1) des ersten Schaltmoduls (SM1) übernimmt, bevor die vierte Ansteuerspannung an das erste Schaltmodul (SM1) angelegt wird.

15. Verfahren nach einem beliebigen der vorhergehenden Ansprüche, wobei die MOSFETs (Q1, Q2) des ersten Schaltmoduls (SM1) und des zweiten Schaltmoduls (SM2) SiC-MOSFETs, vorzugsweise vom gleichen Leitungstyp, besonders bevorzugt selbstsperrende n-Kanal-SiC-MOSFETs sind.

16. Verfahren nach einem beliebigen der vorhergehenden Ansprüche, wobei das Niveau der Ansteuerspannung (UGS1, UGS2) für das erste und das zweite Schaltmodul (SM1, SM2) im Leitendzustand etwa 15-25 Volt, vorzugsweise etwa 20 Volt, das Niveau (U₁) der ersten und vierten Ansteuerspannung etwa 0 bis -10 Volt, vorzugsweise etwa -5 Volt, das Zwischenniveau (U₂) der zweiten Ansteuerspannung etwa -10 bis +4 Volt, vorzugsweise zwischen -3 und +1 Volt, und die Schwellenspannung etwa 2 bis 7 Volt beträgt.

17. Verfahren nach einem beliebigen der vorhergehenden Ansprüche, wobei das Niveau (U₁) der ersten Ansteuerspannung höher ist als das Niveau (U₄) der vierten Ansteuerspannung.

18. Einrichtung zur Steuerung eines Kommutierungsvorgangs eines Laststroms von einem ersten Schaltmodul (SM1) auf ein zweites Schaltmodul (SM2), wobei sowohl das erste als auch das zweite Schaltmodul (SM1, SM2) jeweils einen MOSFET (Q1, Q2), der durch eine Gate-Source-Spannung (UGS1, UGS2) ansteuerbar ist, und eine intrinsische Inversdiode (D1, D2) aufweisen, wobei die Einrichtung eine Gate-Ansteuerungseinrichtung (11) aufweist, die mit einer übergeordneten Steuerung kommunikationsmäßig verbunden ist, um binäre Schaltanforderungssignale (22) von dieser zu erhalten, und eingerichtet ist, um ein Verfahren nach einem beliebigen der vorhergehenden Ansprüche durchzuführen.

19. Steuerungseinrichtung nach Anspruch 18, die wenigstens eine Gate-Treibereinheit (19, 21; 19a-e, 21a-e; 27, 27') aufweist, die in der Lage ist, wenigstens drei unterschiedliche Spannungsniveaus, einschließlich der Niveaus (U1, U2, U2) der ersten, zweiten und dritten Ansteuerspannung, zur Ansteuerung der Schaltmodule (SM1, SM2) zu generieren.

20. Steuerungseinrichtung nach Anspruch 19, wobei die wenigstens eine Gate-Treibereinheit (27, 27') einen ersten ansteuerbaren Schalter (31), der einerseits mit einem positiven Spannungspotential (28) und andererseits über einen Einschaltwiderstand (33, 33-a-c) mit einem Gate (G) des ersten bzw. zweiten Schaltmoduls (SM1, SM2) verbunden ist, und einen zweiten ansteuerbaren Schalter (31, 32) aufweist, der einerseits mit einem negativen Spannungspotential (29) und andererseits über einen Ausschaltwiderstand (34, 34a-c) mit demselben Gate (G) des ersten bzw. zweiten Schaltmoduls (SM1, SM2) verbunden ist, wobei die Spannungspotentiale (28, 29), der Einschaltwiderstand (33, 33-a-c) und der Ausschaltwiderstand (34, 34a-c) derart bemessen sind, dass, wenn beide Schalter (31, 32) gleichzeitig eingeschaltet sind, das Zwischenniveau (U₂) der zweiten Ansteuerspannung an das Gate (G) des ersten bzw. zweiten Schaltmoduls (SM1, SM2) angelegt wird.

## Claims

1. A method for controlling a commutation process of a load current from a first switching module (SM1) to a second switching module (SM2), wherein both the first and second switching modules (SM1, SM2) each comprise a MOSFET (Q1, Q2) which is controllable by a gate-source voltage (U_{GS}), and an intrinsic inverse diode (D1, D2), the method comprising the consecutive steps of:
applying a first control voltage to the first switching module (SM1) to switch it off for a first time period (t₁), wherein the level (U₁, U₁') of the first control voltage is below a predetermined threshold voltage (U_{TH}), above which the MOSFET (Q1) of the first switching module (SM1) becomes minimally conductive, and wherein the first time period (t₁) is selected so that the inverse diode (D1) of the first switching module (SM1) takes over the load current;
applying, upon expiry of the first time period (t₁), a second control voltage to the first switching module (SM1) for a second time period (t₂) to influence the switch-off behavior of the inverse diode (D1) of the first switching module (SM1), wherein the second control voltage has an intermediate level (U₂, U₂') which is between the level (U₁, U₁') of the first control voltage and that of the threshold voltage (U_{TH}),
applying, within the second time period (t₂), a third control voltage to the second switching module (SM2) to switch it on, wherein the level (U₃, U₃') of the third control voltage is above a predetermined threshold voltage (U_{TH}), above which the MOSFET (Q2) of the second switching module (SM2) becomes minimally conductive, in order to cause a commutation of the load current from the inverse diode (D1) of the first switching module (SM1) to the MOSFET (Q2) of the second switching module (SM2); and
applying, upon expiry of the second time period (t₂), a fourth control voltage having a level (U₄, U₄') that is below the intermediate level (U₂, U₂') of the second control voltage to the MOSFET of the first switching module (SM1) to block it or hold it in a blocked state.

2. The method according to claim 1, wherein a second control voltage having an intermediate level (U₂, U₂') which is between the level (U₁, U₁') of a first control voltage to switch off the down-commutating switching module (SM1, SM2) and the level (U_{TH}) of the threshold voltage is applied, for each commutation process from the first switching module (SM1) to the second switching module (SM1, SM2) and vice versa, independent of the instantaneous current flow direction of the load current through the down-commutating switching module (SM1, SM2) before applying a third control voltage (U₃, U₃') to completely switch on the other switching module (SM1, SM2).

3. The method according to claim 1, wherein a second control voltage having an intermediate level (U₂, U₂') which is between the level (U₁, U₁') of a first control voltage to switch off the down-commutating switching module (SM1, SM2) and the level (U_{TH}) of the threshold voltage is applied, for each commutation process from the first switching module (SM1) to the second switching module (SM1, SM2) and vice versa, before applying a third control voltage (U₃, U₃') to completely switch on the other switching module (SM1, SM2) only when the instantaneous load current flows in the reverse flow direction through the down-commutating switching module (SM1, SM2).

4. The method according to any of the preceding claims, wherein the switching on of the switching module (SM1, SM2), to which the load current is commutated, takes place in at least two stages, with an intermediate stage (U₅, U₅') of the control voltage that is below the level (U₃, U₃') of the third control voltage to completely switch on the switching module (SM1, SM2) and is above the threshold voltage (U_{TH}) .

5. The method according to anyone of the preceding claims, wherein the first and second switching modules (SM1, SM2) are arranged in a common commutation circuit and are connected to each other in a directly conductive manner, preferably in series, via line elements.

6. The method according to claim 5, wherein the first and second switching modules (SM1, SM2) form a half-bridge circuit (16; 16a-c) that is connectable or connected to a DC voltage supply, and the connection point between the switching modules (SM1, SM2) forms a bridge tap for the connection of a load.

7. The method according to anyone of the preceding claims, wherein the first and second switching modules (SM1, SM2) form a power module (10, 10') that forms at least one phase branch of a power converter.

8. The method according to claim 7, wherein the power converter has a number of phase branches corresponding to the number of phases, preferably three-phase branches, each phase branch comprising one or more first switching modules (SM1a-e) connected in series and/or parallel to each other and one or more second switching modules (SM2a-e) connected in series and/or parallel to each other.

9. The method according to claim 7 or 8, wherein the power module (10, 10') or each phase branch of the power converter comprises two or more first switching modules (SM1a-e) connected in parallel to each other and two or more second switching modules (SM2a-e) connected in parallel to each other, wherein the first and second switching modules (SM1a-e, SM2a-e) are respectively switched synchronously to each other.

10. The method according to anyone of the preceding claims, wherein the first and second switching modules (SM1, SM2; SM1a-e, SM2a-e) are switched at switching frequencies of a few Hz to kHz, preferably a few tens or hundreds kHz, or in the MHz range.

11. The method according to anyone of the preceding claims, further comprising receiving a switch request signal (22) from a higher-level control, wherein the applying of the first control voltage takes place in response to receiving the switching request signal.

12. The method according to anyone of the preceding claims, wherein the first time period (t₁) is set in advance such that, under the assumed operating conditions, the inverse diode (D1) of the first switching module (SM1) takes over at least 90 %, preferably at least 95 % of the load current from the MOSFET (Q1) of the first switching module (SM1), before the second control voltage is applied.

13. The method according to anyone of the preceding claims, wherein the applying of the third control voltage to the second switching module (SM2) takes place during the second time period (t₂).

14. The method according to claim 13, wherein after applying the third control voltage to the second switching module (SM2) within the second time period (t₂) the MOSFET (Q2) of the second switching module (SM2) takes over at least 90 %, preferably at least 95 % of the load current from the inverse diode (D1) of the first switching module (SM1), before the fourth control voltage is applied to the first switching module (SM1).

15. The method according to anyone of the preceding claims, wherein the MOSFETs (Q1, Q2) of the first switching module (SM1) and the second switching module (SM2) are SiC MOSFETs, preferably of the same conductivity type, and particularly preferably are normally off n-channel SiC MOSFETs.

16. The method according to anyone of the preceding claims, wherein the level of the control voltage (UGS1, UGS2) for the first and second switching modules (SM1, SM2) in the conducting state is approximately 15-25 volts, preferably approximately 20 volts, the level (U₁) of the first and fourth control voltage is approximately 0 to -10 volts, preferably approximately -5 volts, the intermediate level of the second control voltage is approximately -10 to +4 volts, preferably between -3 and +1 volts, and the threshold voltage is approximately 2 to 7 volts.

17. The method according to anyone of the preceding claims, wherein the level (U₁) of the first control voltage is higher than the level (U₄) of the fourth control voltage.

18. A device for controlling a commutation process of a load current from a first switching module (SM1) to a second switching module (SM2), wherein both the first and second switching modules (SM1, SM2) each comprise a MOSFET (Q1, Q2), which is controllable by a gate-source voltage (UGS1, UGS2), and an intrinsic inverse diode (D1, D2), wherein the device comprises a gate control device (11) that is communicatively connected to a higher-level control in order to receive binary switching request signals therefrom, and is configured to perform a method according to anyone of the preceding claims.

19. The control device according to claim 18, comprising at least one gate-driver unit (19, 21; 19a-e, 21a-e; 27, 27') that is capable of generating at least three different voltage levels, including the levels (U1, U2, U2) of the first, second and third control voltage, in order to control the switching modules (SM1, SM2).

20. The control device according to claim 19, wherein the at least one gate-driver unit (27, 27') comprises a first controllable switch (31) that is connected, on the one hand, to a positive voltage potential (28) and, on the other hand, via a switch-on resistor (33, 33-a-c) to a gate (G) of the first and second switching module (SM1, SM2), respectively, and a second controllable switch (31, 32) that is connected, on the one hand, to a negative voltage potential (29) and, on the other hand, via a switch-off resistor (34, 34a-c) to the same gate (G) of the first and second switching module (SM1, SM2), respectively, wherein the voltage potentials (28, 29), the switch-on resistor (33, 33-a-c) and the switch-off resistor (34, 34a-c) are dimensioned such that, when both switches (31, 32) are switched on simultaneously, the intermediate level (U₂) of the second control voltage is applied to the gate (G) of the first and second switching module (SM1, SM2), respectively.

## Revendications

1. Procédé de commande d'un processus de commutation d'un courant de charge d'un premier module de commutation (SM1) sur un second module de commutation (SM2), dans lequel aussi bien le premier que le second module de commutation (SM1, SM2) présentent respectivement un MOSFET (Q1, Q2), qui peut être excité par une tension grille-source (U_{GS}), et une diode inverse intrinsèque (D1, D2), dans lequel le procédé présente les étapes successives :
d'application d'une première tension d'excitation sur le premier module de commutation (SM1) pour la mise hors circuit de celui-ci pour un premier laps de temps (t₁), dans lequel le niveau (U₁, U₁') de la première tension d'excitation se situe au-dessous d'une tension de seuil (U_{TH}) prédéfinie, au-dessus de laquelle le MOSFET (Q1) du premier module de commutation (SM1) devient conducteur de façon minimale, et
dans lequel le laps de temps (t₁) est choisi afin que la diode inverse (D1) du premier module de commutation (SM1) réceptionne le courant de charge ;
d'application, après expiration du premier laps de temps (t₁), d'une deuxième tension d'excitation sur le premier module de commutation (SM1) pour un second laps de temps (t₂), afin d'influer sur le comportement de mise hors circuit de la diode inverse (D1) du premier module de commutation (SM1),
dans lequel la deuxième tension d'excitation présente un niveau intermédiaire (U₂, U₂'), qui se situe entre le niveau (U₁, U₁') de la première tension d'excitation et celui de la tension de seuil (U_{TH}),
d'application, pendant le second laps de temps (t₂), d'une troisième tension d'excitation sur le second module de commutation (SM2) pour la mise en circuit de ce dernier, dans lequel le niveau (U₃, U₃') de la troisième tension d'excitation se situe au-dessus d'une tension de seuil (U_{TH}) prédéfinie, au-dessus de laquelle le MOSFET (Q2) du second module de commutation (SM2) devient conducteur de façon minimale, afin de provoquer une commutation du courant de charge de la diode inverse (D1) du premier module de commutation (SM1) sur le MOSFET (Q2) du second module de commutation (SM2) ; et
d'application, après expiration du second laps de temps (t₂), d'une quatrième tension d'excitation avec un niveau (U₄, U₄'), qui se situe au-dessous du niveau intermédiaire (U₂, U₂') de la deuxième tension d'attaque, sur le MOSFET du premier module de commutation (SM1), afin de bloquer celui-ci ou de le maintenir dans l'état bloqué.

2. Procédé selon la revendication 1, dans lequel une deuxième tension d'excitation avec un niveau intermédiaire (U₂, U₂'), qui se situe entre le niveau (U₁, U₁') d'une première tension d'excitation destinée à mettre hors circuit le module de commutation (SM1, SM2) à décommuter et le niveau (U_{TH}) de la tension de seuil, pour chaque processus de commutation du premier module de commutation (SM1) sur le second module de commutation (SM1, SM2) et inversement, indépendamment de la direction de flux de courant momentanée du courant de charge à travers le module de commutation (SM1, SM2) à décommuter, est appliquée avant l'application d'une troisième tension d'excitation (U3, U3') destinée à la mise en circuit intégrale de l'autre module de commutation (SM1, SM2).

3. Procédé selon la revendication 1, dans lequel une deuxième tension d'excitation avec un niveau intermédiaire (U₂, U₂'), qui se situe entre le niveau (U₁, U₁') d'une première tension d'excitation destinée à mettre hors circuit le module de commutation (SM1, SM2) à décommuter et le niveau (U_{TH}) de la tension de seuil, pour chaque processus de commutation du premier module de commutation (SM1) sur le second module de commutation (SM1, SM2) et inversement, avant l'application d'une troisième tension d'excitation (U₃, U₃') destinée à la mise en circuit intégrale de l'autre module de commutation (SM1, SM2), n'est appliquée que lorsque le courant de charge momentané circule dans la direction d'écoulement arrière à travers le module de commutation (SM1, SM2) à décommuter.

4. Procédé selon l'une quelconque des revendications précédentes, dans lequel la mise en circuit du module de commutation (SM1, SM2), sur lequel le courant de charge est commuté, s'effectue au moins sur deux étages, avec un étage intermédiaire (U₅, U₅') de la tension d'excitation, qui se situe au-dessous du niveau (U₃, U₃') de la troisième tension d'excitation destinée à la mise en circuit intégrale du module de commutation (SM1, SM2) et au-dessus de la tension de seuil (U_{TH}).

5. Procédé selon l'une quelconque des revendications précédentes, dans lequel le premier et le deuxième module de commutation (SM1, SM2) sont disposés dans un circuit de commutation (16) commun et sont reliés l'un à l'autre de manière directement conductrice de préférence en série par l'intermédiaire d'éléments conducteurs.

6. Procédé selon la revendication 5, dans lequel le premier et le second module de commutation (SM1, SM2) forment un montage en demi-pont (16 ; 16a-c), qui peut être raccordé ou est raccordé à une alimentation en tension continue, et le point de liaison entre les modules de commutation (SM1, SM2) forme une prise de pont (17) pour le raccordement d'une charge (12).

7. Procédé selon l'une quelconque des revendications précédentes, dans lequel le premier et le second module de commutation (SM1, SM2) forment un module de puissance (10, 10'), qui forme au moins une branche de phase d'un convertisseur.

8. Procédé selon la revendication 7, dans lequel le convertisseur présente un nombre de branches de phase, de préférence trois branches de phase, correspondant au nombre des phases, dans lequel chaque branche de phase présente un ou plusieurs premiers modules de commutation (SM1a-e) montés en série et/ou parallèlement les uns aux autres et un ou plusieurs seconds modules de commutation (SM2a-e) montés en série et/ou parallèlement les uns aux autres.

9. Procédé selon la revendication 7 ou 8, dans lequel le module de puissance (10, 10') ou chaque branche de phase du convertisseur présente deux premiers modules de commutation (SM1a-e) ou plus montés parallèlement les uns aux autres et deux seconds modules de commutation (SM2a-e) ou plus montés parallèlement les uns aux autres, dans lequel les premiers et les seconds module de commutation (SM1a-e, SM2a-e) sont montés respectivement de manière synchrone les uns par rapport aux autres.

10. Procédé selon l'une quelconque des revendications précédentes, dans lequel les premiers et seconds modules de commutation (SM1, SM2 ; SM1a-e, SM2a-e) sont commutés avec des fréquences de commutation allant de quelques Hz à kHz, de préférence quelques dizaines ou cent kHz, ou dans la plage des MHz.

11. Procédé selon l'une quelconque des revendications précédentes, que présente en outre une réception d'un signal de demande de commutation (22) par une commande supérieure, dans lequel l'application de la première tension d'excitation s'effectue en réponse à la réception du signal de demande de commutation (22).

12. Procédé selon l'une quelconque des revendications précédentes, dans lequel le premier laps de temps (t1) est établi à l'avance, de telle sorte que la diode inverse (D1) du premier module de commutation (SM1), dans les conditions de fonctionnement admises, réceptionne au moins 90 %, de préférence au moins 95 % du courant de charge du MOSFET (Q1) du premier module de commutation (SM1), avant que la deuxième tension d'excitation ne soit appliquée.

13. Procédé selon l'une quelconque des revendications précédentes, dans lequel l'application de la troisième tension d'excitation sur le second module de commutation (SM2) s'effectue pendant le second laps de temps (t2).

14. Procédé selon la revendication 13, dans lequel, après l'application de la troisième tension d'excitation sur le second module de commutation (SM2) pendant le second laps de temps (t2), le MOSFET (Q2) du second module de commutation (SM2) réceptionne au moins 90 %, de préférence au moins 95 % du courant de charge de la diode inverse (D1) du premier module de commutation (SM1), avant que la quatrième tension d'excitation ne soit appliquée sur le premier module de commutation (SM1).

15. Procédé selon l'une quelconque des revendications précédentes, dans lequel les MOSFET (Q1, Q2) du premier module de commutation (SM1) et du second module de commutation (SM2) sont des MOSFET-SiC, de préférence du même type de conductivité, de manière particulièrement préférée des MOSFET-SiC à n canaux à blocage automatique.

16. Procédé selon l'une quelconque des revendications précédentes, dans lequel le niveau de la tension d'excitation (UGS1, UGS2) pour le premier et le second module de commutation (SM1, SM2) atteint dans l'état conducteur sensiblement 15-25 Volt, de préférence sensiblement 20 Volt, le niveau (U₁) de la première et quatrième tension d'excitation sensiblement 0 à -10 Volt, de préférence sensiblement -5 Volt, le niveau intermédiaire (U₂) de la deuxième tension d'excitation sensiblement -10 à +4 Volt, de préférence entre -3 et +1 Volt, et la tension de seuil sensiblement 2 à 7 Volt.

17. Procédé selon l'une quelconque des revendications précédentes, dans lequel le niveau (U₁) de la première tension d'excitation est supérieur au niveau (U₄) de la quatrième tension d'excitation.

18. Dispositif pour la commande d'un processus de commutation d'un courant de charge d'un premier module de commutation (SM1) sur un second module de commutation (SM2), dans lequel aussi bien le premier que le second module de commutation (SM1, SM2) présentent respectivement un MOSFET (Q1, Q2), qui peut être excité par une tension grille-source (UGS1, UGS2), et une diode inverse intrinsèque (D1, D2), dans lequel le dispositif présente un dispositif d'excitation de grille (11), qui est relié par communication à une commande supérieure, afin d'obtenir de celle-ci des signaux de demande de commutation (22) binaires, et est conçu pour mettre en œuvre un procédé selon l'une quelconque des revendications précédentes.

19. Dispositif de commande selon la revendication 18, qui présente au moins une unité d'attaque de grille (19, 21 ; 19a-e, 21a-e ; 27, 27'), qui est en mesure de générer au moins trois différents niveaux de tension, y compris des niveaux (U1, U2, U2) des première, deuxième et troisième tensions d'excitation, pour l'excitation des modules de commutation (SM1, SM2).

20. Dispositif de commande selon la revendication 19, dans lequel l'au moins une unité d'attaque de grille (27, 27') présente un premier commutateur (31) pouvant être excité, qui est relié d'une part à un potentiel de tension positif (28) et d'autre part, par l'intermédiaire d'une résistance de mise en circuit (33, 33-a-c), à une grille (G) du premier ou second module de commutation (SM1, SM2), et un second commutateur (31, 32) pouvant être excité, qui est relié d'une part à un potentiel de tension négative (29) et d'autre part par l'intermédiaire d'une résistance de mise hors circuit (34, 34a-c) à la même grille (G) du premier ou second module de commutation (SM1, SM2), dans lequel les potentiels de tension (28, 29), la résistance de mise en circuit (33, 33-a-c) et la résistance de mise hors circuit (34, 34a-c) sont mesurés de telle sorte que, lorsque les deux commutateurs (31, 32) sont mis en circuit simultanément, le niveau intermédiaire (U₂) de la deuxième tension d'excitation est appliqué sur la grille (G) du premier ou second module de commutation (SM1, SM2).
